# EUROPEAN PATENT APPLICATION

(11) **EP 1 830 227 A1**
(43) Date of publication of application: **05.09.2007**
(21) Application number: 05811760.7
(22) Date of filing: 01.12.2005
(51) Int. Cl.: G03F 7/004, G03F 7/039, H01L 21/027

(54) **RESIST COMPOSITION FOR LIQUID IMMERSION EXPOSURE AND METHOD FOR RESIST PATTERN FORMATION**

(30) Priority: 20.12.2004 JP 2004367971
(71) Applicant: TOKYO OHKA KOGYO CO., LTD., Kawasaki-shi, Kanagawa 211-0012 (JP)
(72) Inventor: MATSUMARU, Shogo, c/o TOKYO OHKA KOGYO CO., LTD., Kawasaki-shi, Kanagawa 2110012 (JP); TSUJI, Hiromitsu, c/o TOKYO OHKA KOGYO CO., LTD., Kawasaki-shi, Kanagawa 2110012 (JP)
(74) Representative: Portal, Gérard
(86) International application number: PCT/JP2005/022121
(87) International publication number: WO 2006/067944

(57) **Abstract**

A resist composition for immersion exposure including a resin component (A) that exhibits changed alkali solubility under the action of acid, wherein the resin component (A) includes a polymer compound (A1) containing a structural unit (a0) having an acid-generating group that generates acid upon irradiation.

## Description

### TECHNICAL FIELD

The present invention relates to a resist composition for immersion exposure that is used in a method for resist pattern formation that includes an immersion exposure step (lithography that includes an immersion exposure step is referred to as immersion lithography), and a method for resist pattern formation.
Priority is claimed on Japanese Patent Application No. 2004-367971, filed December 20, 2004, the content of which is incorporated herein by reference.

### BACKGROUND ART

Lithography methods are widely used in the production of microscopic structures in a variety of electronic devices such as semiconductor devices and liquid crystal devices, and ongoing miniaturization of the structures of these devices has lead to demands for further miniaturization of the resist patterns used in these lithography processes. With current lithography methods, using the most up-to-date ArF excimer lasers, fine resist patterns with a line width of approximately 90 nm are able to be formed, but in the future, even finer pattern formation will be required.

In order to enable the formation of these types of ultra fine patterns of less than 90 nm, the development of appropriate exposure apparatus and corresponding resists is the first requirement.
In the case of resists, chemically amplified resists, which enable high levels of resolution to be achieved, are able to utilize a catalytic reaction or chain reaction of an acid generated by irradiation, exhibit a quantum yield of 1 or greater, and are capable of achieving high sensitivity, are attracting considerable attention, and development of these resists is flourishing.
In positive chemically amplified resists, resins having acid-dissociable, dissolution-inhibiting groups are the most commonly used. Examples of known acid-dissociable, dissolution-inhibiting groups include acetal groups such as ethoxyethyl groups, tertiary alkyl groups such as tert-butyl groups, as well as tert-butoxycarbonyl groups and tert-butoxycarbonylmethyl groups. Furthermore, structural units derived from tertiary ester compounds of (meth)acrylic acid, such as 2-alkyl-2-adamantyl (meth)acrylates, are widely used as the structural units containing an acid-dissociable, dissolution-inhibiting group within the resin component of conventional ArF resist compositions, as disclosed in the patent reference 1 listed below.
On the other hand, in the case of the exposure apparatus, techniques such as shortening the wavelength of the light source used, and increasing the diameter of the lens aperture (NA) (namely, increasing NA) are common. For example, for a resist resolution of approximately 0.5 µm, a mercury lamp for which the main spectrum is the 436 nm g-line is used, for a resolution of approximately 0.5 to 0.30 µm, a similar mercury lamp for which the main spectrum is the 365 nm i-line is used, for a resolution of approximately 0.3 to 0.15 µm, 248 nm KrF excimer laser light is used, and for resolutions of approximately 0.15 µm or less, 193 nm ArF excimer laser light is used. In order to achieve even greater miniaturization, the use of F₂ excimer laser light (157 nm), Ar₂ excimer laser light (126 nm), EUV (extreme ultraviolet radiation: 13 nm), EB (electron beams), and X-rays and the like is also being investigated.
However, shortening the wavelength of the light source requires a new and expensive exposure apparatus. Furthermore, if the NA value is increased, then because the resolution and the depth of focus range exist in a trade-off type relationship, even if the resolution is increased, a problem arises in that the depth of focus reduces.

Against this background, a method known as immersion exposure (lithography that includes an immersion exposure step is referred to as immersion lithography) has been reported (for example, see non-patent references 1 to 3). This is a method in which exposure (immersion exposure) is conducted with the region between the lens and the resist layer disposed on top of the wafer, which has conventionally been filled with air or an inert gas such as nitrogen, filled with a solvent (a immersion medium) that has a larger refractive index than the refractive index of air.
According to this type of immersion exposure, it is claimed that higher resolutions equivalent to those obtained using a shorter wavelength light source or a larger NA lens can be obtained using the same exposure light source wavelength, with no reduction in the depth of focus. Furthermore, immersion exposure can be conducted using existing exposure apparatus. As a result, it is predicted that immersion exposure will enable the formation of resist patterns of higher resolution and superior depth of focus at lower costs. Accordingly, in the production of semiconductor elements, which requires enormous capital investment, immersion exposure is attracting considerable attention as a method that offers significant potential to the semiconductor industry, both in terms of cost and in terms of lithography properties such as resolution.
Currently, water is mainly used as the immersion medium for immersion lithography.
[Patent Reference 1]
   Japanese Unexamined Patent Application, First Publication No. Hei 10-161313
[Non-Patent Reference 1] Journal of Vacuum Science & Technology B (U.S.), 1999, vol. 17, issue 6, pp. 3306 to 3309.
[Non-Patent Reference 2] Journal of Vacuum Science & Technology B (U.S.), 2001, vol. 19, issue 6, pp. 2353 to 2356.
[Non-Patent Reference 3] Proceedings of SPIE (U.S.), 2002, vol. 4691, pp. 459 to 465.

### DISCLOSURE OF INVENTION

However, many factors associated with immersion exposure remain unknown, and the formation of an ultra fine resist pattern of a level suitable for actual use remains problematic. For example, when an attempt was made to apply conventional KrF resist compositions and ArF resist compositions to immersion exposure, either patterns were unable to be formed, or even if formed, the resulting resist pattern shapes were unsatisfactory, with problems including undulations within the line patterns and roughness within the side wall surfaces of the resist pattern, so-called line edge roughness (LER). As the miniaturization of resist patterns continues to progress, the demands for higher levels of resolution will increase, making improvements in the above shape problems more and more critical.
The present invention takes these problems associated with the conventional technology into consideration, with an object of providing a resist composition for immersion exposure and a method for resist pattern formation that enable the formation of a resist pattern of favorable shape.

As a result of intensive investigation, the inventors of the present invention discovered that by using a polymer compound having an acid-generating group that generates acid upon irradiation (exposure), the above object could be achieved, and they were therefore able to complete the present invention.
In other words, a first aspect of the present invention is a resist composition for immersion exposure that includes a resin component (A) that exhibits changed alkali solubility under the action of acid, wherein the resin component (A) includes a polymer compound (A1) containing a structural unit (a0) having an acid-generating group that generates acid upon irradiation.
A second aspect of the present invention is a method for resist pattern formation that includes the steps of: forming a resist film on a substrate using the resist composition for immersion exposure of the first aspect, conducting immersion exposure of the resist film, and developing the resist film to form a resist pattern.

In the following description, the meanings of the terms used are as listed below.
A "structural unit" refers to a monomer unit that contributes to the formation of a polymer (polymer compound).
A "structural unit derived from acrylic acid" refers to a structural unit formed by cleavage of the ethylenic double bond of acrylic acid. The term "acrylic acid" is deemed to include not only acrylic acid, in which a hydrogen atom is bonded to the α-position carbon atom, but also structures in which this α-position hydrogen atom is substituted with another substituent group such as a halogen atom, alkyl group, or haloalkyl group.
A "structural unit derived from an acrylate ester" refers to a structural unit formed by cleavage of the ethylenic double bond of an acrylate ester. The term "acrylate ester" is deemed to include not only the acrylate ester, in which a hydrogen atom is bonded to the α-position carbon atom, but also structures in which this α-position hydrogen atom is substituted with another substituent group such as a halogen atom, alkyl group, or haloalkyl group.
In a "structural unit derived from acrylic acid" or a "structural unit derived from an acrylate ester", unless stated otherwise, the term "α-position" or "α-position carbon atom" refers to the carbon atom to which the carboxyl group is bonded.
An "alkyl group", unless stated otherwise, refers to a straight-chain, branched-chain, or cyclic alkyl group.
The term "exposure" is used as a general concept that includes irradiation with any form of radiation.

The present invention is able to provide a resist composition for immersion exposure and a method for resist pattern formation that enable the formation of a resist pattern of favorable shape.

### BEST MODE FOR CARRYING OUT THE INVENTION

### «Resist Composition for Immersion Exposure»

A resist composition for immersion exposure according to the present invention includes a resin component (A) (hereafter referred to as the component (A)) that exhibits changed alkali solubility under the action of acid, wherein the resin component (A) includes a polymer compound (A1) containing a structural unit (a0) having an acid-generating group that generates acid upon irradiation.
The resist composition for immersion exposure according to the present invention may be either a so-called positive composition, in which the component (A) is an alkali-insoluble resin that exhibits increased alkali solubility under the action of acid, or a so-called negative composition, in which the component (A) is an alkali-soluble resin that becomes alkali-insoluble under the action of acid. A resist composition of the present invention is preferably a positive composition.
In the case of a negative composition, a cross-linking agent is blended into the resist composition with the component (A). Then, during resist pattern formation, when acid is generated from the structural unit (a0) of the polymer compound (A1) upon exposure (irradiation), the action of this acid causes cross linking between the component (A) and the cross linking agent, causing the composition to become alkali-insoluble. As the cross linking agent, melamine that contains a methylol group or alkoxymethyl group, or an amino-based cross linking agent such as urea or glycoluril or the like is usually used.
In the case of a positive composition, the component (A) is an alkali-insoluble resin containing so-called acid-dissociable, dissolution-inhibiting groups, and when acid is generated from the structural unit (a0) of the polymer compound (A1) upon exposure, this acid causes the acid-dissociable, dissolution-inhibiting groups to dissociate, making the resin component (A) alkali-soluble.

The polymer compound (A1) contains a structural unit (a0) having an acid-generating group that generates acid upon irradiation.

### - Structural Unit (a0)

There are no particular restrictions on the acid-generating group, provided the group is able to generate an acid upon irradiation, and suitable examples include groups derived from known acid generators used in conventional chemically amplified resist compositions, such as the compounds exemplified in relation to an acid generator component (B) described below. Here, the expression "group derived from an acid generator" refers to a group in which one hydrogen atom has been removed from the acid generator structure.
For example, in the case of onium salt-based acid generators, structures formed from a cation portion such as an iodonium ion or sulfonium ion having an organic group such as an aryl group or an alkyl group, and an anion portion such as a sulfonate ion, such as the salts shown below in formulas (b-1) and (b-2), are in widespread use. Acid-generating groups derived from onium salt-based acid generators include groups formed by removing one hydrogen atom from an organic group of the cation portion of the onium salt-based acid generator.
Furthermore, in the case of oxime sulfonate-based acid generators, suitable examples of acid-generating groups include groups formed by removing one hydrogen atom from an organic group of an oxime sulfonate-based acid generator with a structure represented by a general formula (B-1) shown below.

In the present invention, in order to ensure superior effects for the invention, the acid-generating group is preferably a group that includes a sulfonate ion.
Examples of acid-generating groups having a sulfonate ion include acid-generating groups derived from the aforementioned onium salt-based acid generators in which the anion portion is a sulfonate ion. In these acid-generating groups, the anion portion (the sulfonate ion) dissociates upon irradiation, and that sulfonate ion then acts as an acid.

There are no particular restrictions on the structure of the structural unit (a0), provided it includes an acid-generating group described above. In terms of achieving superior transparency relative to light of wavelength 193 nm or shorter, and achieving excellent resolution, structural units derived from acrylate esters are preferred. Of these units, structures in which the acid-generating group is bonded to the ester group [-C(O)O-] of the structural unit derived from an acrylate ester (namely, structures in which the hydrogen atom of the carboxyl group is substituted with the acid-generating group) are preferred.

Specific examples of preferred examples of the structural unit (a0) include structural units represented by a general formula (a0-1) shown below.

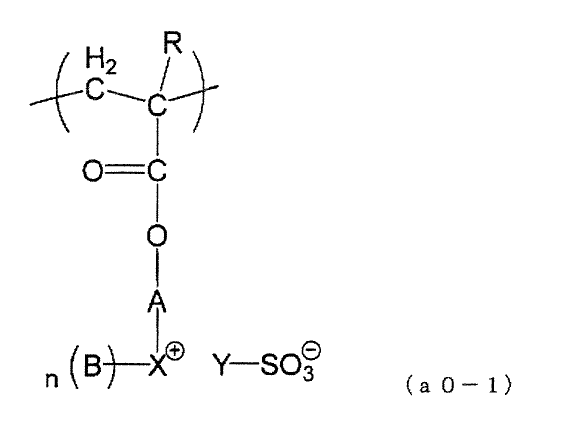

[wherein, R represents a hydrogen atom, halogen atom, lower alkyl group, or halogenated lower alkyl group; A represents a bivalent organic group; B represents a monovalent organic group; X represents a sulfur atom or iodine atom; n represents either 1 or 2; and Y represents a straight-chain, branched or cyclic alkyl group in which at least one hydrogen atom may be substituted with a fluorine atom]

In the formula (a0-1), R represents a hydrogen atom, halogen atom, lower alkyl group, or halogenated lower alkyl group.
Examples of suitable halogen atoms for the group R include a fluorine atom, chlorine atom, bromine atom and iodine atom, and a fluorine atom is particularly preferred.
A lower alkyl group represented by R is preferably a straight-chain or branched alkyl group of 1 to 5 carbon atoms, and suitable examples include a methyl group, ethyl group, propyl group, isopropyl group, n-butyl group, isobutyl group, tert-butyl group, pentyl group, isopentyl group, and neopentyl group. A methyl group is preferred industrially.
A halogenated lower alkyl group represented by R is a group in which either a portion of, or all of, the hydrogen atoms within an aforementioned lower alkyl group have been substituted with halogen atoms. In such a halogenated lower alkyl group, examples of the halogen atoms used for substituting the hydrogen atoms include fluorine atoms, chlorine atoms, bromine atoms and iodine atoms, and fluorine atoms are particularly preferred.
Of the above possibilities, R is preferably a hydrogen atom or a methyl group.

Examples of the bivalent organic group represented by A include straight-chain, branched or cyclic alkylene groups of 1 to 20 carbon atoms, and groups in which two hydrogen atoms have been removed from an aromatic ring structure of 4 to 20 carbon atoms, and within these groups, a carbon atom may be substituted with a hetero atom such as an oxygen atom. Particularly preferred groups include straight-chain, branched or cyclic alkylene groups of 1 to 10 carbon atoms (such as a methylene group, ethylene group, propylene group, or cyclohexylene group), and groups in which two hydrogen atoms have been removed from an aromatic ring structure of 6 to 15 carbon atoms (such as a phenylene group or naphthylene group).
These alkylene groups or aromatic ring structures may also contain substituent groups. There are no particular restrictions on these substituent groups, and suitable examples include straight-chain or branched alkyl groups of 1 to 20 carbon atoms, and a hydroxyl group or the like, although from the viewpoint of ensuring superior resolution, alkyl groups of 1 to 10 carbon atoms are preferred, and alkyl groups of I to 5 carbon atoms are particularly desirable. Specific examples of suitable groups include a methyl group, ethyl group, n-propyl group, isopropyl group, n-butyl group, isobutyl group, n-pentyl group, cyclopentyl group, hexyl group, cyclohexyl group, nonyl group and decanyl group. A methyl group is particularly preferred in terms of yielding superior resolution, and enabling low-cost synthesis.

Examples of the monovalent organic group represented by B include straight-chain, branched, or cyclic alkyl groups of 1 to 20 carbon atoms, and groups in which one hydrogen atom has been removed from an aromatic ring structure of 4 to 20 carbon atoms, and within these groups, a carbon atom may be substituted with a hetero atom such as an oxygen atom or nitrogen atom. Particularly preferred groups include straight-chain, branched, or cyclic alkyl groups of 1 to 10 carbon atoms (such as a methyl group, ethyl group, propyl group, or cyclohexyl group), and groups in which one hydrogen atom has been removed from an aromatic ring structure of 6 to 15 carbon atoms (such as a phenyl group or naphthyl group).
These alkyl groups or aromatic ring structures may also contain substituent groups. There are no particular restrictions on these substituent groups, and suitable examples include the same straight-chain, branched or cyclic alkyl groups of 1 to 20 carbon atoms as those described above as suitable substituent groups within the group A.

The group X represents a sulfur atom or an iodine atom, and is preferably a sulfur atom.
n represents either 1 or 2, and when X represents a sulfur atom, n = 2, whereas when X represents an iodine atom, n = 1.
The straight-chain, branched or cyclic alkyl group represented by Y preferably contains from 1 to 10 carbon atoms, and even more preferably from 1 to 8 carbon atoms, and most preferably from I to 4 carbon atoms. In these alkyl groups, at least one hydrogen atom may be substituted with a fluorine atom, and alkyl groups in which all of the hydrogen atoms have been substituted with fluorine atoms are particularly preferred. As the group Y, straight-chain alkyl groups in which all of the hydrogen atoms have been substituted with fluorine atoms are particularly desirable.

As the structural unit (a0), structural units represented by a general formula (a0-2) shown below yield particularly superior effects for the present invention, and are consequently preferred.

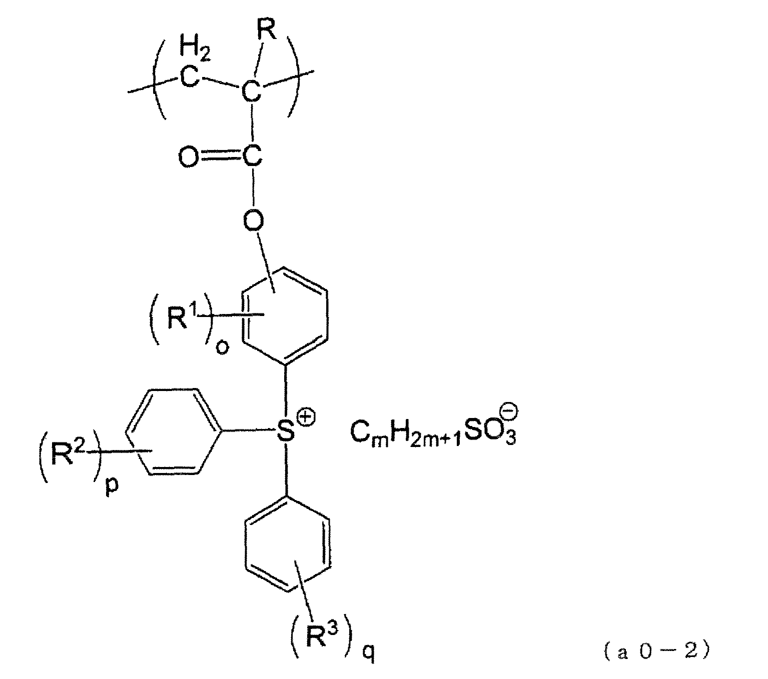

[wherein, R represents a hydrogen atom, halogen atom, lower alkyl group, or halogenated lower alkyl group; R¹ to R³ each represent, independently, a straight-chain, branched, or cyclic alkyl group of 1 to 20 carbon atoms, or a hydroxyl group; o, p, and q each represent, independently, either 0 or an integer from 1 to 3; m represents an integer from 1 to 10; and the hydrogen atoms within the anion portion may be substituted with fluorine atoms]

In the formula (a0-2), R is as described above in relation to the formula (a0-1).
Examples of the straight-chain, branched, or cyclic alkyl groups of 1 to 20 carbon atoms represented by R¹ to R³ include the same alkyl groups that are exemplified above as potential substituent groups for the alkyl groups or aromatic ring structures within the description relating to the group B.
o, p, and q each represent, independently, either 0 or an integer from 1 to 3, and of these possibilities, the cases in which o represents 2 and p and q both represent 0 are preferred.
m represents an integer from 1 to 10, preferably an integer from 1 to 8, and even more preferably an integer from 1 to 4, and those cases where m is either 1 or 4 are the most preferred in terms of the ease of industrial synthesis.
Furthermore, within the anion portion (CₘH₂ₘ₊₁SO₃⁻), the alkyl group represented by CₘH₂ₘ₊₁ may be either a straight-chain or a branched group, but is preferably a straight-chain alkyl group such as a methyl group, ethyl group, n-propyl group, n-butyl group, n-pentyl group, n-hexyl group, n-heptyl group, n-octyl group, n-nonyl group, or n-decyl group. Furthermore, at least 50%, even more preferably 80% or more, and most preferably 100%, of the hydrogen atoms of this alkyl group may be substituted with fluorine atoms.

Specific examples of the structural unit (a0) include the structural units represented by general formulas (a0-3) and (a0-4) shown below, and of these, structural units represented by the general formula (a0-3) are particularly preferred.

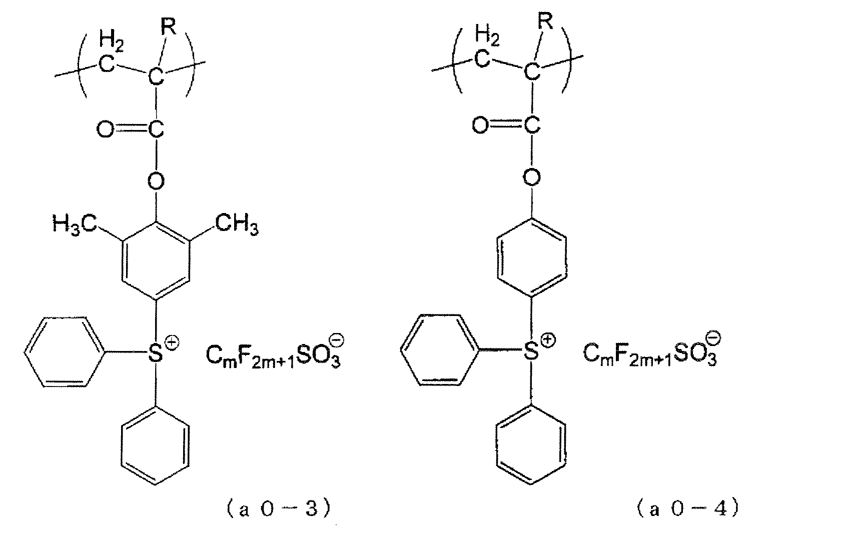

[wherein, R represents a hydrogen atom, halogen atom, lower alkyl group, or halogenated lower alkyl group; and m represents an integer from 1 to 10]

Monomers that give rise to the structural unit (a0) can be synthesized easily by an esterification reaction between an acryloyl chloride and an acid generator that is capable of reaction with the acryloyl chloride (such as an onium salt that includes a hydroxyl group within the cation portion).

As the structural unit (a0), either a single type of structural unit may be used alone, or a combination of two or more different structural units may be used.
From the viewpoint of maximizing the effect of the present invention, the proportion of the structural unit (a0) within the polymer compound (A1), relative to the combined total of all the structural units that constitute the polymer compound (A1), is preferably at least 0.01 mol%, even more preferably 0.1 mol% or higher, and is most preferably 1 mol% or higher. Furthermore, considering the need to achieve a favorable balance with the other structural units, the upper limit for this proportion is preferably no higher than 70 mol%, even more preferably no higher than 50 mol%, even more preferably no higher than 30 mol%, and is most preferably 15 mol% or lower.

### - Structural Unit (a1)

In those cases where the resist composition for immersion exposure of the present invention is a positive composition, the polymer compound (A1) preferably includes a structural unit (a1) derived from an acrylate ester containing an acid-dissociable, dissolution-inhibiting group.
In the structural unit (a1), examples of the substituent group at the α-position of the acrylate ester include the same α-position substituents as those described for the aforementioned structural unit (a0).

The acid-dissociable, dissolution-inhibiting group in the structural unit (a1) can use any of the groups that have been proposed as acid-dissociable, dissolution-inhibiting groups for the base resins of chemically amplified resists, provided the group has an alkali dissolution-inhibiting effect that renders the entire polymer compound (A1) alkali-insoluble prior to exposure, and then following dissociation, causes the entire polymer compound (A1) to change to an alkali-soluble state. Generally, groups that form either a cyclic or chain-like tertiary alkyl ester, or a cyclic or chain-like alkoxyalkyl ester with the carboxyl group of the (meth)acrylate ester are the most widely known. Here, the term "(meth)acrylate ester" is a generic term that includes the acrylate ester and/or the methacrylate ester.

Here, a tertiary alkyl ester describes a structure in which an ester is formed by substituting the hydrogen atom of a carboxyl group with an alkyl group or a cycloalkyl group, and a tertiary carbon atom within the alkyl group or cycloalkyl group is bonded to the oxygen atom at the terminal of the carbonyloxy group (-C(O)-O-). In this tertiary alkyl ester, the action of acid causes cleavage of the bond between the oxygen atom and the tertiary carbon atom.
The aforementioned alkyl group or cycloalkyl group may contain a substituent group.
Hereafter, for the sake of simplicity, groups that exhibit acid dissociability as a result of the formation of a tertiary alkyl ester at a carboxyl group are referred to as "tertiary alkyl ester-based acid-dissociable, dissolution-inhibiting groups".
Furthermore, a cyclic or chain-like alkoxyalkyl ester describes a structure in which an ester is formed by substituting the hydrogen atom of a carboxyl group with an alkoxyalkyl group, wherein the alkoxyalkyl group is bonded to the oxygen atom at the terminal of the carbonyloxy group (-C(O)-O-). In this alkoxyalkyl ester, the action of acid causes cleavage of the bond between the oxygen atom and the alkoxyalkyl group.

As the structural unit (a1), the use of one or more structural units selected from the group consisting of structural units represented by a general formula (a1-0-1) shown below and structural units represented by a general formula (a1-0-2) shown below is preferred.

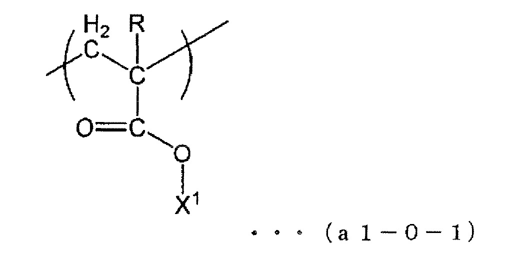

(wherein, R represents a hydrogen atom, halogen atom, lower alkyl group, or halogenated lower alkyl group; and X¹ represents an acid-dissociable, dissolution-inhibiting group)

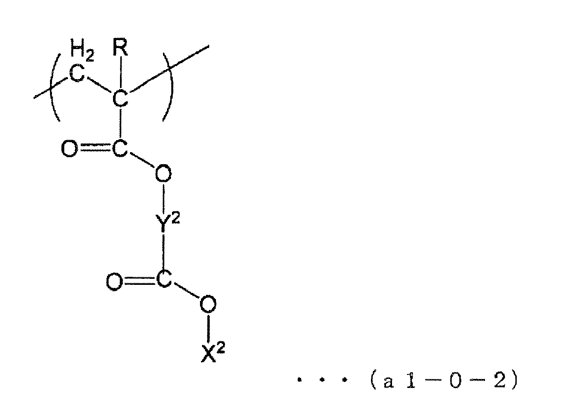

(wherein, R represents a hydrogen atom, halogen atom, lower alkyl group, or halogenated lower alkyl group; X² represents an acid-dissociable, dissolution-inhibiting group; and Y² represents an aliphatic cyclic group)

In the general formula (a1-0-1), R is as described above in relation to the general formula (a0-1).
There are no particular restrictions on the group X¹, provided it functions as an acid-dissociable, dissolution-inhibiting group, and suitable examples include an alkoxyalkyl group or a tertiary alkyl ester-based acid-dissociable, dissolution-inhibiting group, although a tertiary alkyl ester-based acid-dissociable, dissolution-inhibiting group is preferred. Examples of suitable tertiary alkyl ester-based acid-dissociable, dissolution-inhibiting groups include aliphatic branched-chain acid-dissociable, dissolution-inhibiting groups and acid-dissociable, dissolution-inhibiting groups that contain an aliphatic cyclic group.
The term "aliphatic" used in the claims and description of the present invention is a relative concept used in relation to the term "aromatic", and defines a group or compound or the like that contains no aromaticity. The term "aliphatic cyclic group" describes a monocyclic group or polycyclic group that contains no aromaticity.
The "aliphatic cyclic group" within the structural unit (a1) may either contain, or not contain, substituent groups. Examples of suitable substituent groups include lower alkyl groups of 1 to 5 carbon atoms, a fluorine atom, fluorinated lower alkyl groups of 1 to 5 carbon atoms that have undergone substitution with a fluorine atom, and an oxygen atom (=0) or the like.
The basic ring structure of the "aliphatic cyclic group" excluding substituent groups is not restricted to groups formed solely from carbon and hydrogen (hydrocarbon groups), although a hydrocarbon group is preferred. Furthermore, the "hydrocarbon group" may be either saturated or unsaturated, but is usually saturated. The group is preferably a polycyclic group.
Specific examples of this type of aliphatic cyclic group include groups in which one or more hydrogen atoms have been removed from a polycycloalkane such as a monocycloalkane, bicycloalkane, tricycloalkane or tetracycloalkane, which may, or may not, be substituted with a fluorine atom or a fluoroalkyl group. Specific examples of suitable groups include groups in which one or more hydrogen atoms have been removed from a monocycloalkane such as cyclopentane or cyclohexane, or a polycycloalkane such as adamantane, norbornane, isobornane, tricyclodecane or tetracyclododecane.
Specific examples of suitable aliphatic branched-chain acid-dissociable, dissolution-inhibiting groups include a tert-butyl group and a tert-amyl group.
Furthermore, examples of acid-dissociable, dissolution-inhibiting groups that contain an aliphatic cyclic group include groups that contain a tertiary carbon atom within the ring skeleton of a cycloalkyl group, and specific examples include a 2-methyladamantyl group or 2-ethyladamantyl group. Other possible groups include those that contain an aliphatic cyclic group such as an adamantyl group, and a branched-chain alkylene group that contains a tertiary carbon atom and is bonded to the aliphatic cyclic group, such as the group shown within the structural unit represented by a general formula shown below.

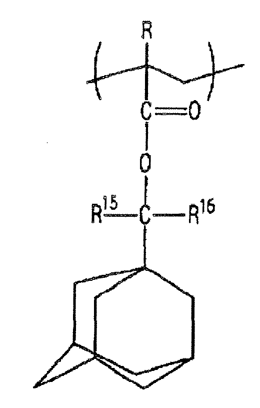

[wherein, R is as defined above, and R¹⁵ and R¹⁶ represent alkyl groups (which may be either straight-chain or branched-chain groups, and preferably contain from 1 to 5 carbon atoms)]

Furthermore, the above alkoxyalkyl groups are preferably groups represented by a general formula shown below.

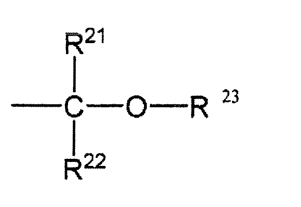

(wherein, R²¹ and R²² each represent, independently, an alkyl group or a hydrogen atom, and R²³ represents an alkyl group or a cycloalkyl group. Furthermore, R²¹ and R²³ may be bonded together at their respective terminals to form a ring)

The number of carbon atoms within an alkyl group of the groups R²¹ and R²² is preferably from 1 to 15, and the group may be either a straight-chain or branched-chain group, although an ethyl group or methyl group is preferred, and a methyl group is the most desirable.
Those cases in which one of the groups R²¹ and R²² is a hydrogen atom and the other is a methyl group are particularly desirable.
R²³ is an alkyl group or a cycloalkyl group, the number of carbon atoms within the group is preferably from 1 to 15, and the group may be a straight-chain, branched-chain or cyclic group. In those cases where R²³ is a straight-chain or branched-chain group, the number of carbon atoms is preferably from 1 to 5, an ethyl group or methyl group is preferred, and an ethyl group is particularly desirable.
In those cases where R²³ is a cyclic group, the number of carbon atoms is preferably from 4 to 15, even more preferably from 4 to 12, and is most preferably from 5 to 10. Specific examples of this type of cyclic group include groups in which one or more hydrogen atoms have been removed from a monocycloalkane or a polycycloalkane such as a bicycloalkane, tricycloalkane or tetracycloalkane, which may, or may not, be substituted with a fluorine atom or a fluoroalkyl group. Specific examples of suitable groups include groups in which one or more hydrogen atoms have been removed from a monocycloalkane such as cyclopentane or cyclohexane, or a polycycloalkane such as adamantane, norbornane, isobornane, tricyclodecane or tetracyclododecane. Of these, groups in which one or more hydrogen atoms have been removed from adamantane are particularly desirable.
Furthermore, in the above formula, R²¹ and R²³ may each represent independent alkylene groups of 1 to 5 carbon atoms, wherein the terminal of R²³ and the terminal of R²¹ are bonded together.
In such cases, a cyclic group is formed from the groups R²¹ and R²³, the oxygen atom bonded to R²³, and the carbon atom that is bonded to this oxygen atom and the group R²¹. This type of cyclic group is preferably a 4- to 7-membered ring, and 4- to 6- membered rings are even more desirable. Specific examples of these cyclic groups include a tetrahydropyranyl group and a tetrahydrofuranyl group.

In the general formula (a1-0-2), R is as defined above. The group X² is as described for X¹ in the formula (al-0-1).
Y² is a bivalent aliphatic cyclic group. Because Y² is a bivalent aliphatic cyclic group, with the exception of using groups in which two or more hydrogen atoms have been removed, the same "aliphatic cyclic groups" as those described in relation to the above formula (a1-0-1) can be used.

Specific examples of the structural unit (a1) include the structural units represented by general formulas (a1-1) to (a1-4) shown below.

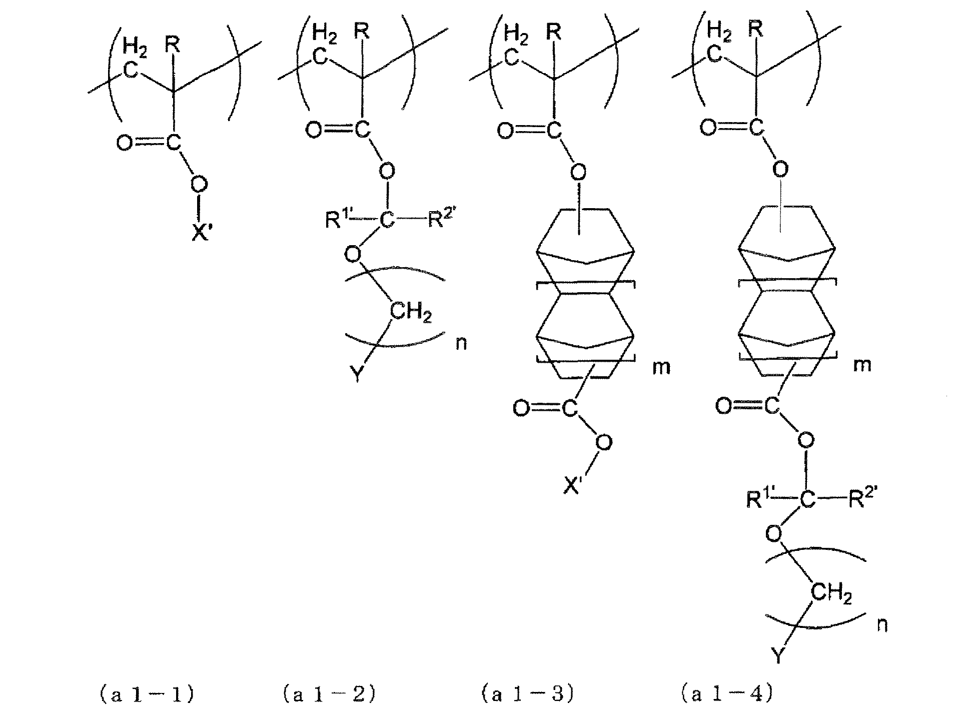

[wherein, X' represents a tertiary alkyl ester-based acid-dissociable, dissolution-inhibiting group, Y represents a lower alkyl group of 1 to 5 carbon atoms or an aliphatic cyclic group, n represents either 0 or an integer from 1 to 3, m represents either 0 or 1, R is as defined above, and R^{1'} and R^{2'} each represent, independently, a hydrogen atom or a lower alkyl group of I to 5 carbon atoms]

At least one of the groups R^{1'} and R^{2'} is preferably a hydrogen atom, and units in which both R^{1'} and R^{2'} are hydrogen atoms are even more preferred. n is preferably either 0 or 1.

X' represents the same tertiary alkyl ester-based acid-dissociable, dissolution-inhibiting groups as those described above in relation to the group X¹.
Examples of the aliphatic cyclic group represented by Y include the same "aliphatic cyclic groups" as those exemplified above in the description relating to the formula (a1-0-1).

Specific examples of the structural units represented by the above general formulas (a1-1) to (a1-4) are shown below.

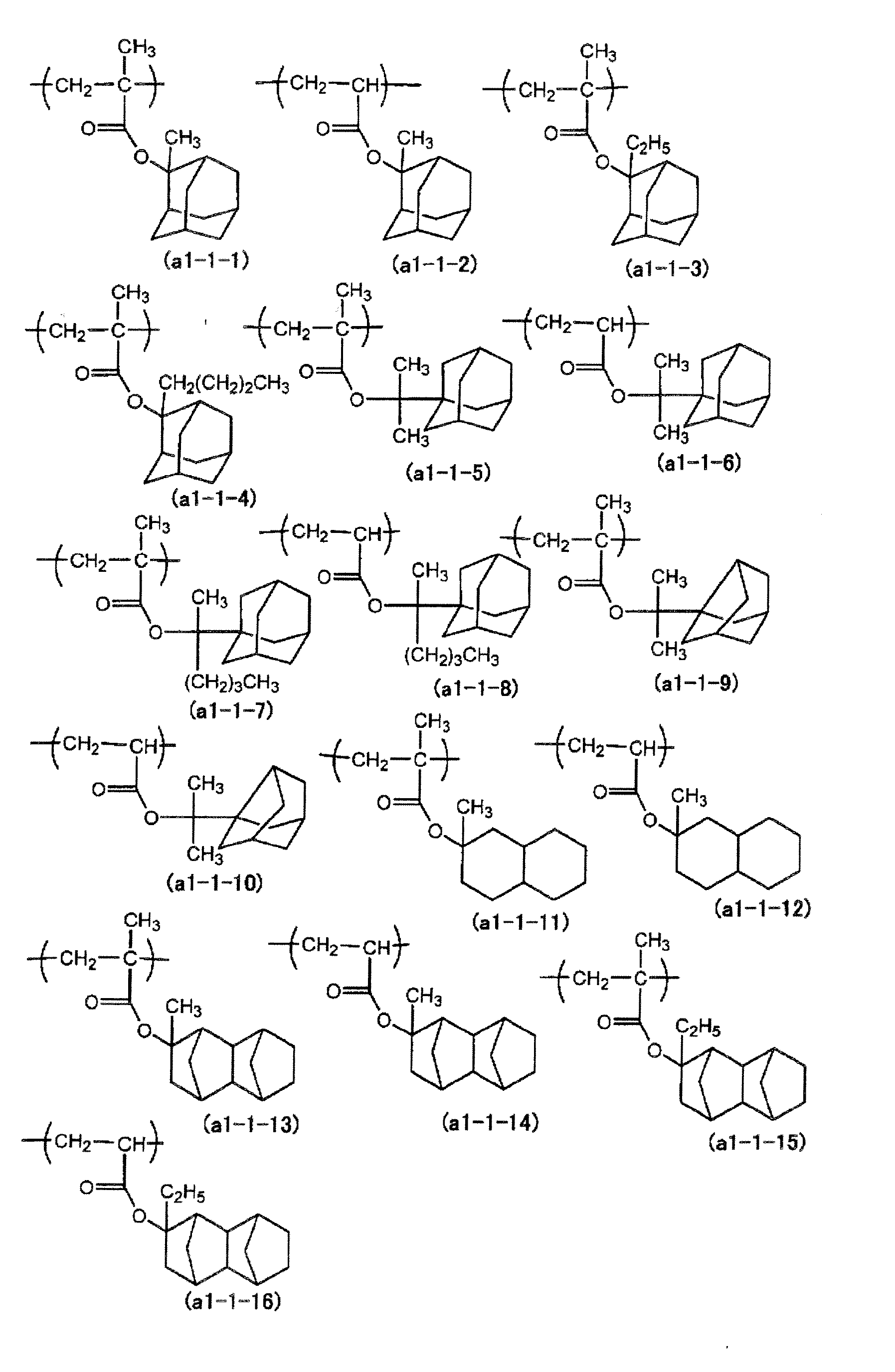

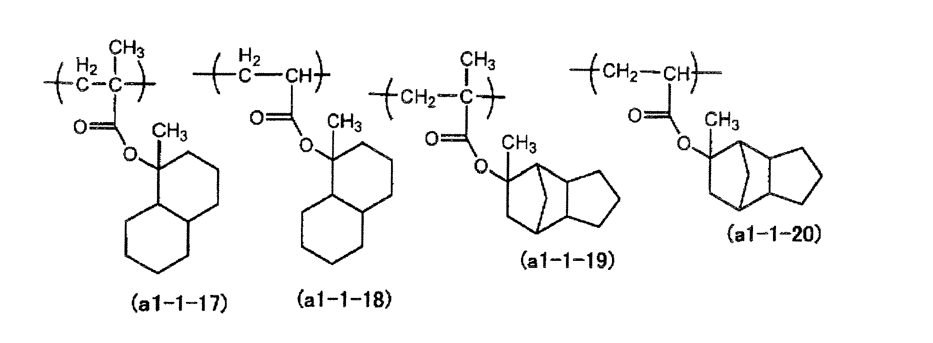

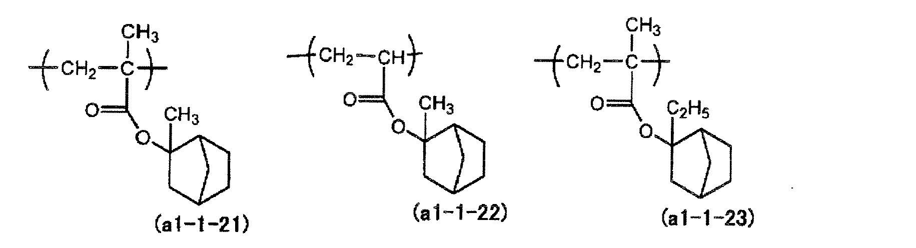

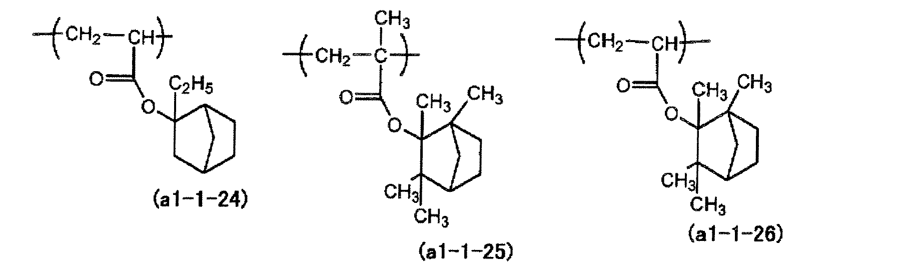

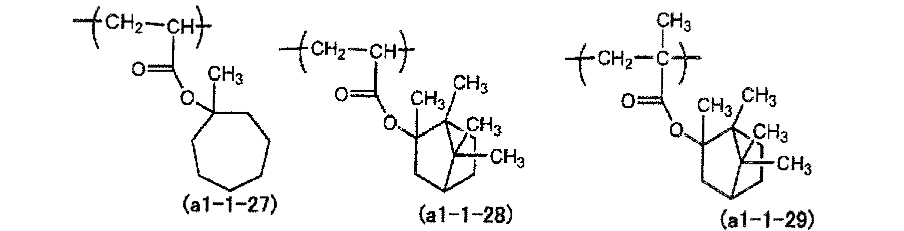

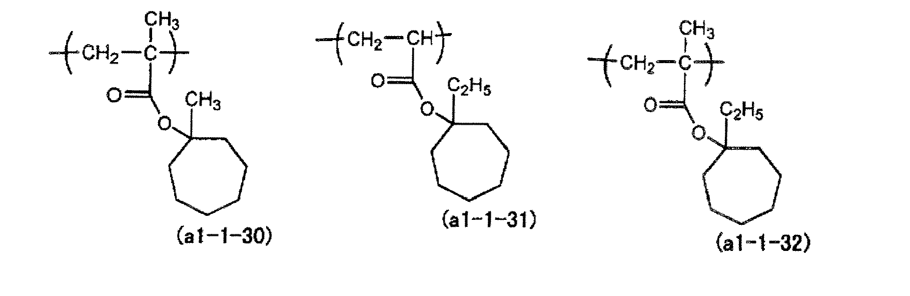

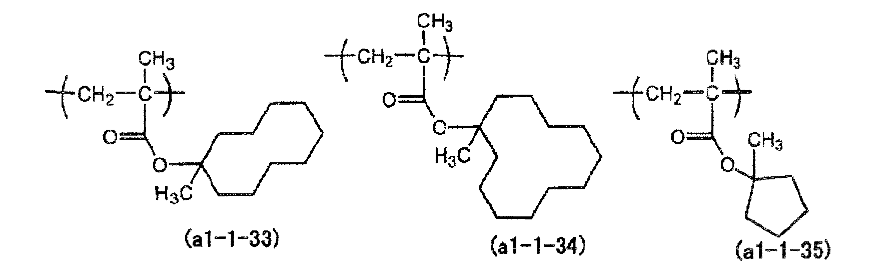

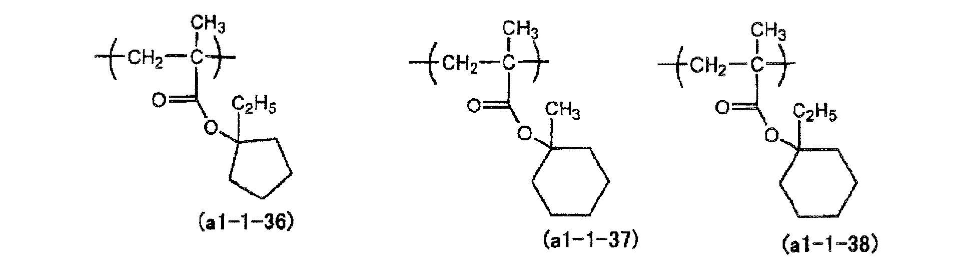

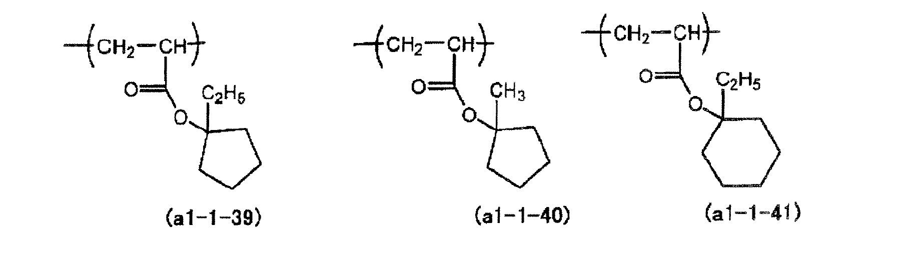

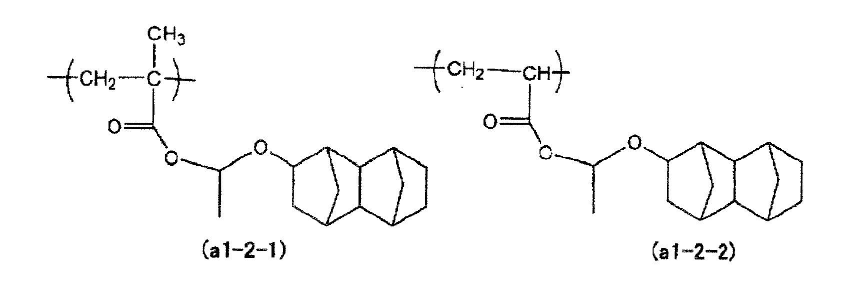

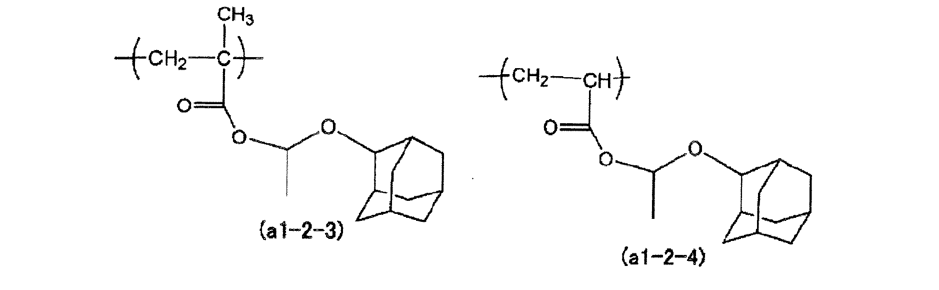

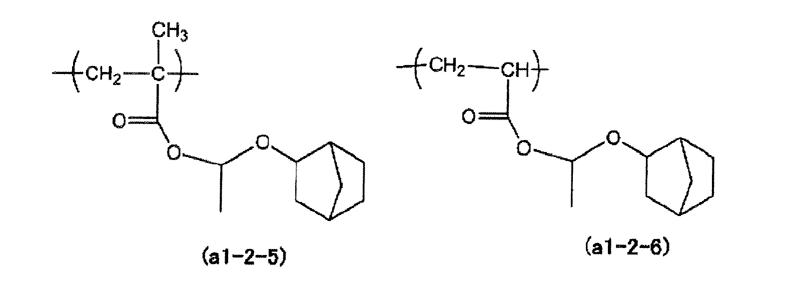

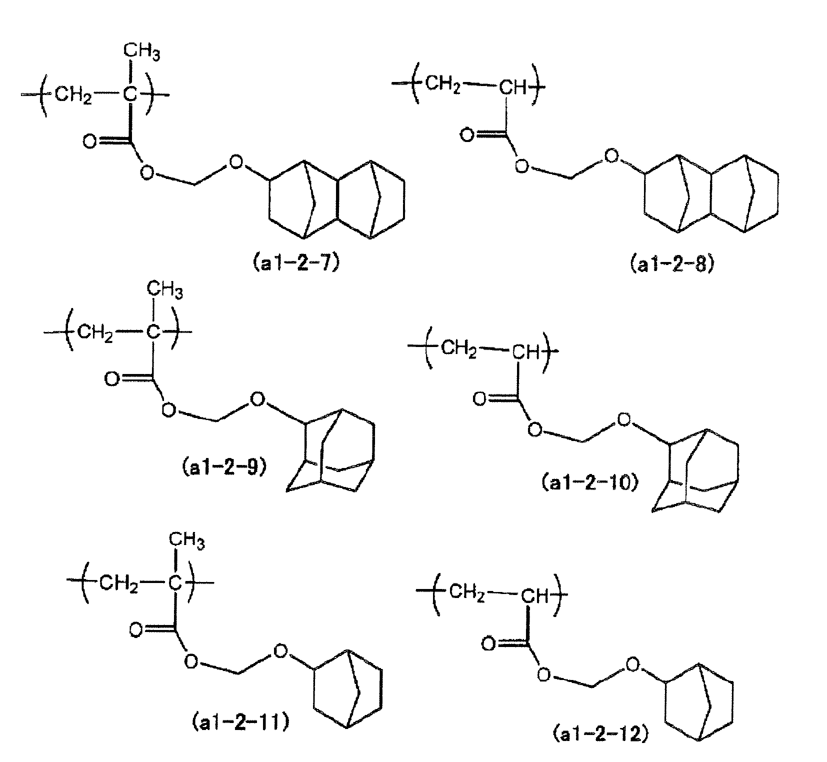

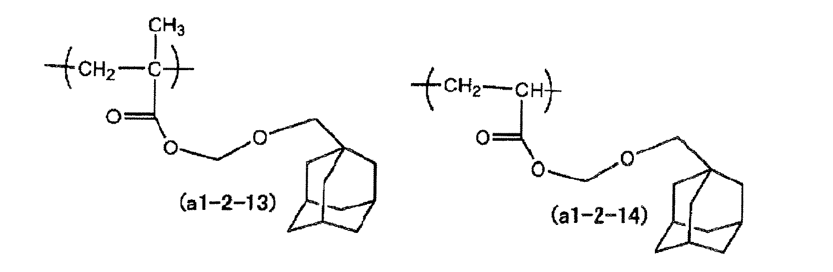

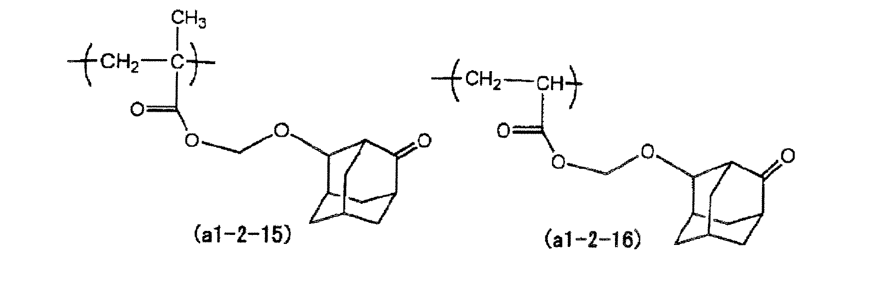

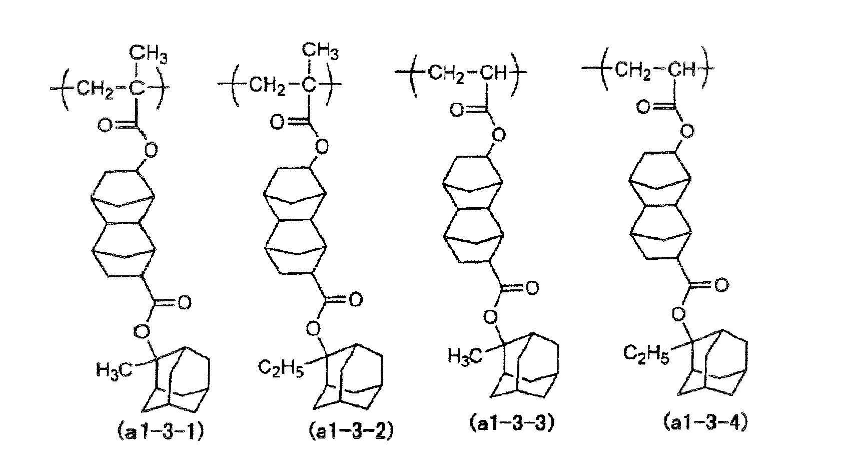

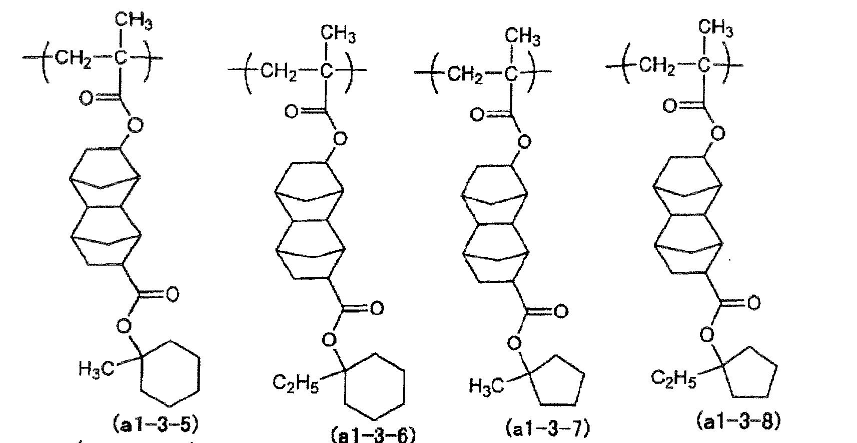

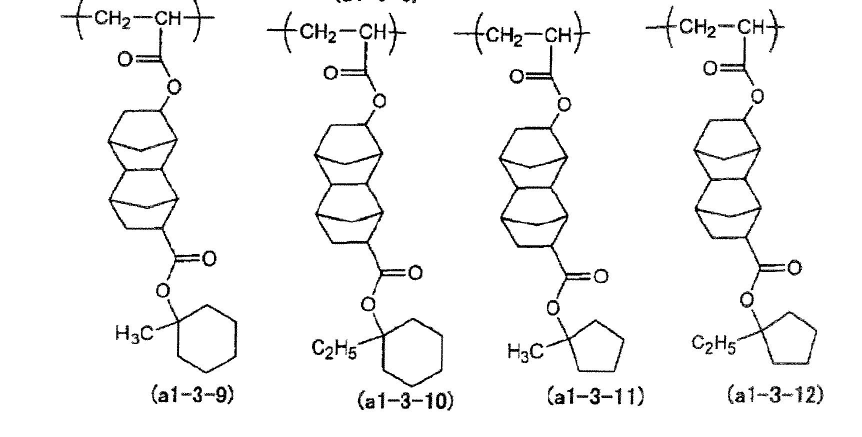

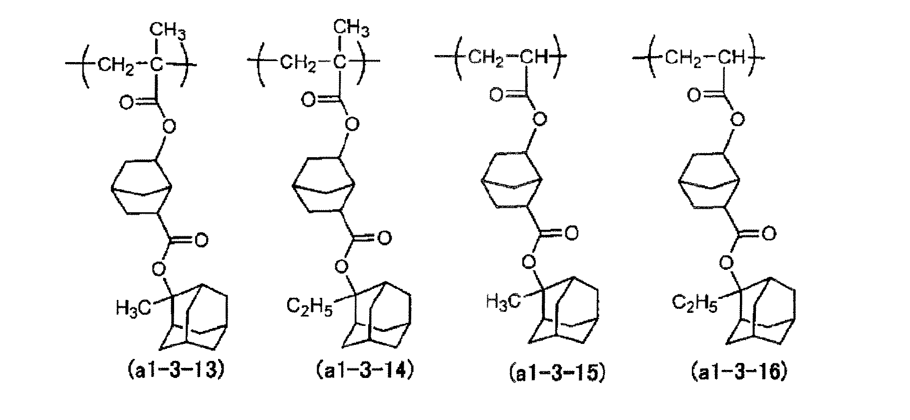

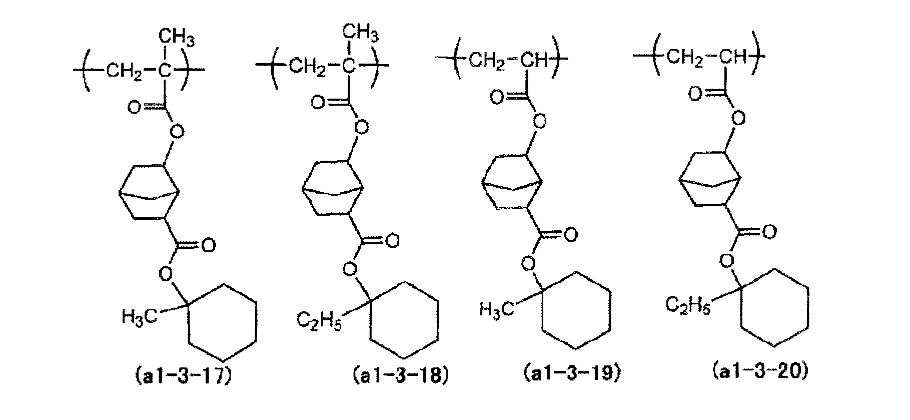

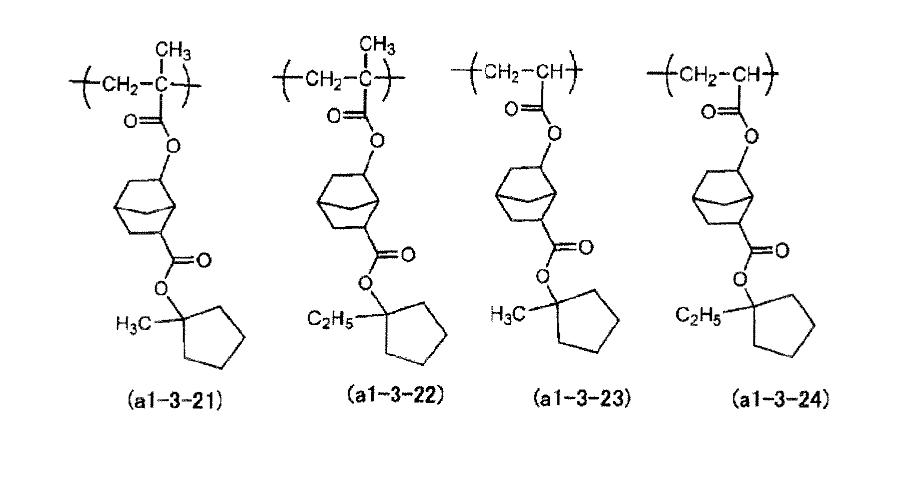

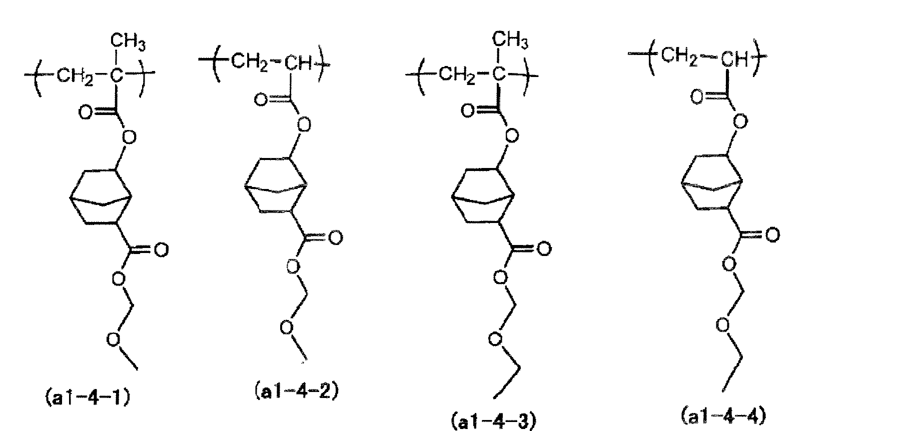

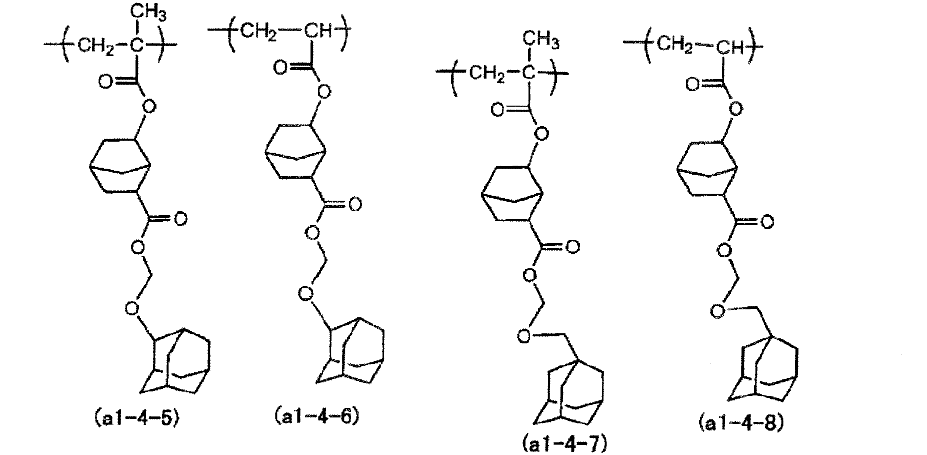

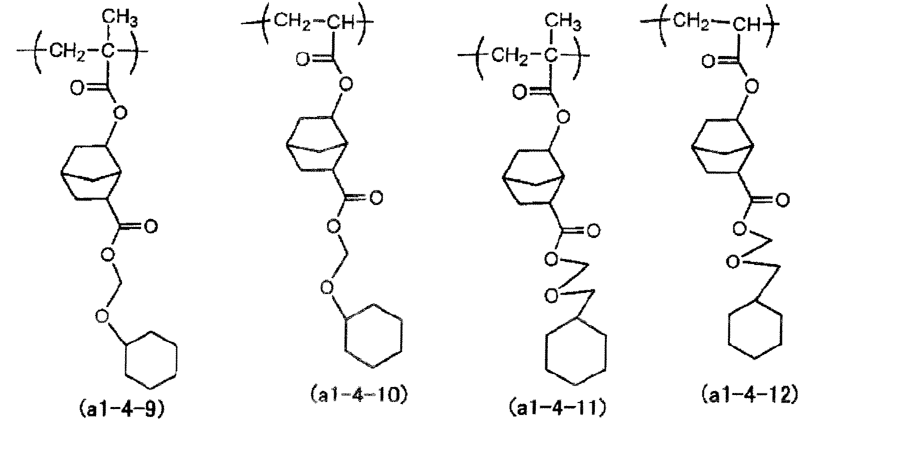

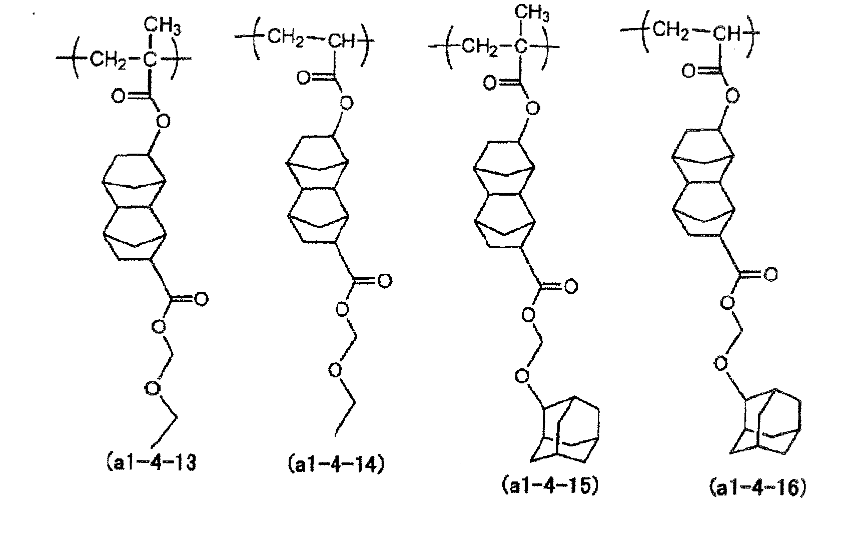

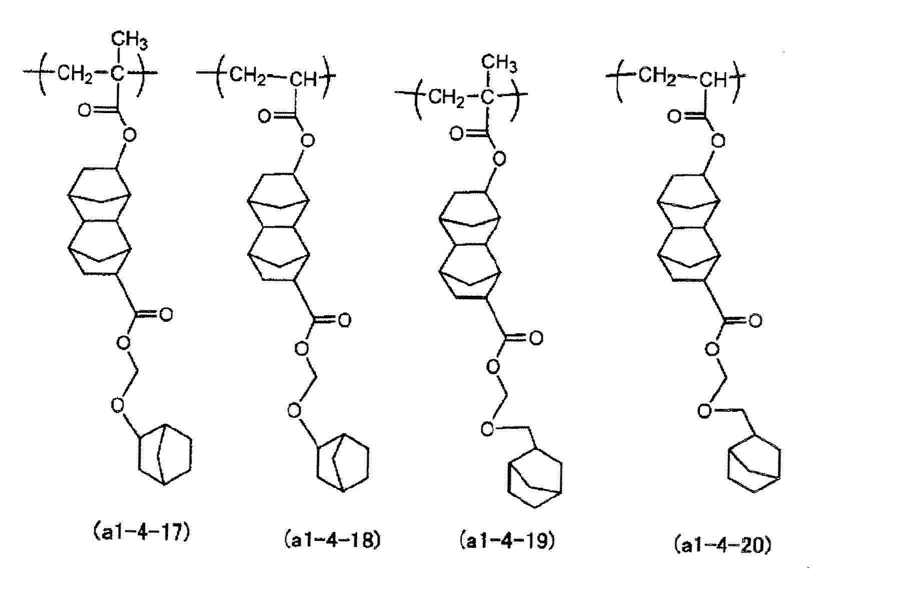

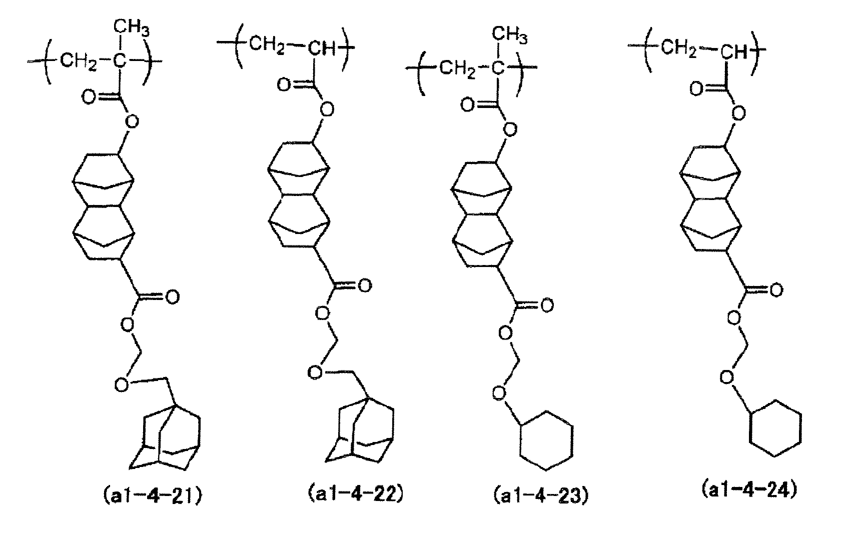

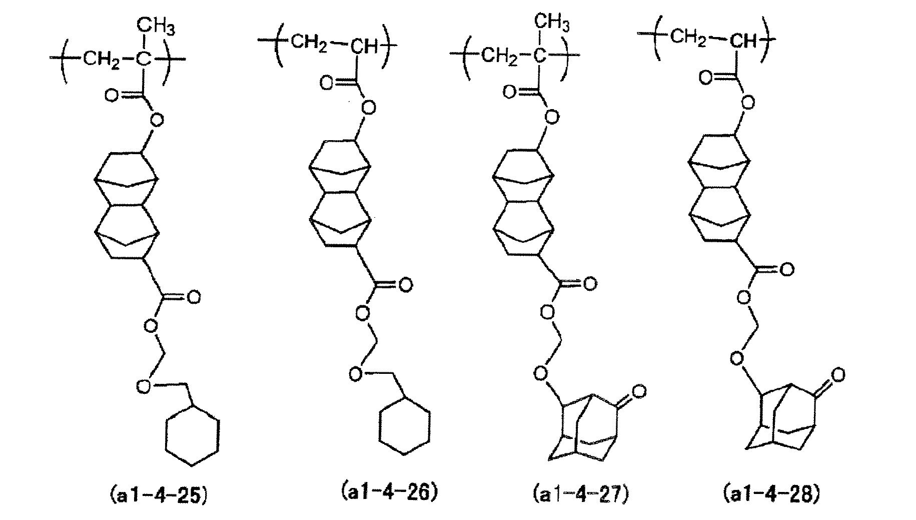

As the structural unit (a1), either a single type of structural unit may be used alone, or a combination of two or more different structural units may be used. Of the various possibilities, structural units represented by the general formula (a1-1) are preferred, and one or more units selected from amongst structural units represented by the formulas (a1-1-1) to (a1-1-6) and the formulas (a1-1-35) to (a1-1-41) are the most desirable.
Moreover, as the structural unit (a1), units represented by a general formula (a1-1-01) shown below, which includes the structural units of the formulas (a1-1-1) through (a1-1-4), and units represented by a general formula (a1-1-02) shown below, which includes the structural units of the formulas (a1-1-36), (a1-1-38), (a1-1-39) and (a1-1-41) are particularly desirable.

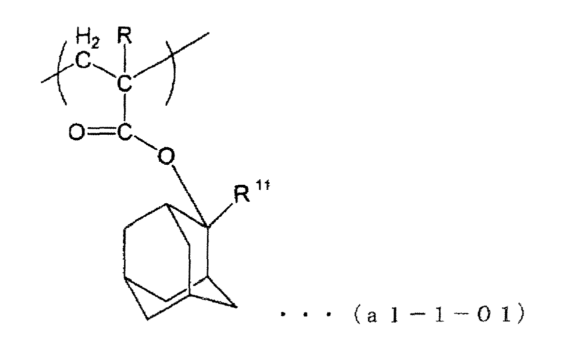

(wherein, R represents a hydrogen atom, halogen atom, lower alkyl group, or halogenated lower alkyl group, and R¹¹ represents a lower alkyl group)

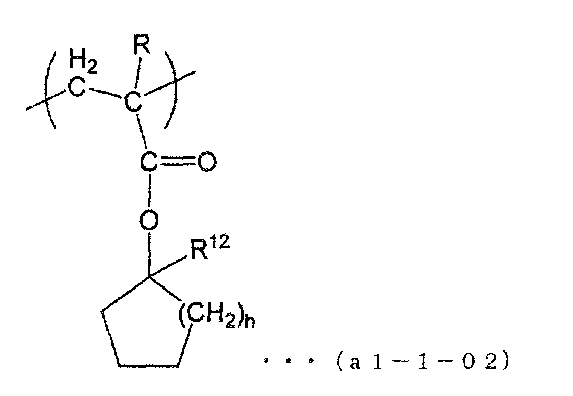

(wherein, R represents a hydrogen atom, halogen atom, lower alkyl group, or halogenated lower alkyl group, R¹² represents a lower alkyl group, and h represents an integer from 1 to 3)

In the general formula (a1-1-01), R is as defined above. The lower alkyl group of R¹¹ is the same as the lower alkyl group defined for the group R, and is preferably a methyl group or ethyl group.

In the general formula (a1-1-02), R is as defined above. The lower alkyl group of R¹² is the same as the lower alkyl group defined for the group R, is preferably a methyl group or ethyl group, and is most preferably an ethyl group. h is preferably either 1 or 2, and is most preferably 2.

The proportion of the structural unit (a1) within the polymer compound (A1), relative to the combined total of all the structural units that constitute the polymer compound (A1), is preferably within a range from 10 to 80 mol%, even more preferably from 20 to 70 mol%, and is most preferably from 25 to 50 mol%. Ensuring that this proportion is at least as large as the lower limit of the above range enables a more favorable pattern to be obtained when the polymer is used in a resist composition, whereas ensuring that the proportion is no greater than the upper limit enables a more favorable balance to be achieved with the other structural units.

### - Structural Unit (a2)

In addition to the aforementioned structural unit (a0), or in addition to the combination of the aforementioned structural units (a0) and (a1), the polymer compound (A1) preferably also includes a structural unit (a2) derived from an acrylate ester that contains a lactone-containing monocyclic or polycyclic group.
In this structural unit (a2), examples of the substituent group at the α-position of the acrylate ester include the same α-position substituent groups as those described above for the structural unit (a0).
The lactone-containing monocyclic or polycyclic group of the structural unit (a2) is effective in improving the adhesion of the resist film to the substrate and enhancing the hydrophilicity relative to the developing solution when the polymer compound (A1) is used in the formation of a resist film.
There, a lactone-containing monocyclic or polycyclic group refers to a cyclic group that contains a ring containing a -O-C(O)- structure (namely, a lactone ring). This lactone ring is counted as the first ring, and groups that contain only the lactone ring are referred to as monocyclic groups, whereas groups that also contain other ring structures are described as polycyclic groups regardless of the structure of the other rings.

As the structural unit (a2), any group can be used without any particular restrictions, provided it includes both the above type of lactone structure (-O-C(O)-) and a cyclic group.
Specifically, examples of lactone-containing monocyclic groups include groups in which one hydrogen atom has been removed from γ-butyrolactone. Furthermore, examples of lactone-containing polycyclic groups include groups in which one hydrogen atom has been removed from a lactone ring-containing bicycloalkane, tricycloalkane, or tetracycloalkane. Groups obtained by removing one hydrogen atom from a lactone-containing tricycloalkane with a structural formula such as those shown below are particularly preferred in terms of factors such as industrial availability.

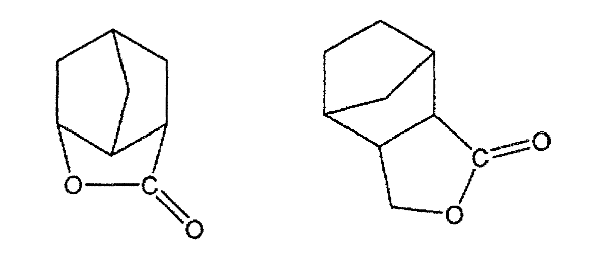

More specific examples of the structural unit (a2) include the structural units represented by general formulas (a2-1) to (a2-5) shown below.

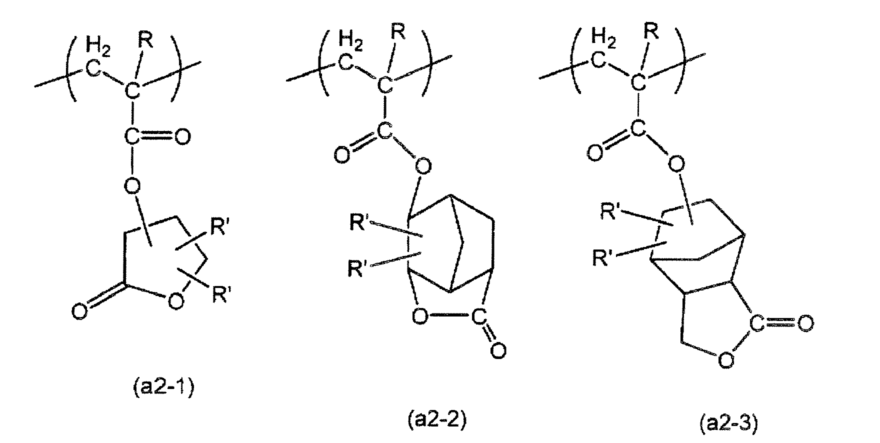

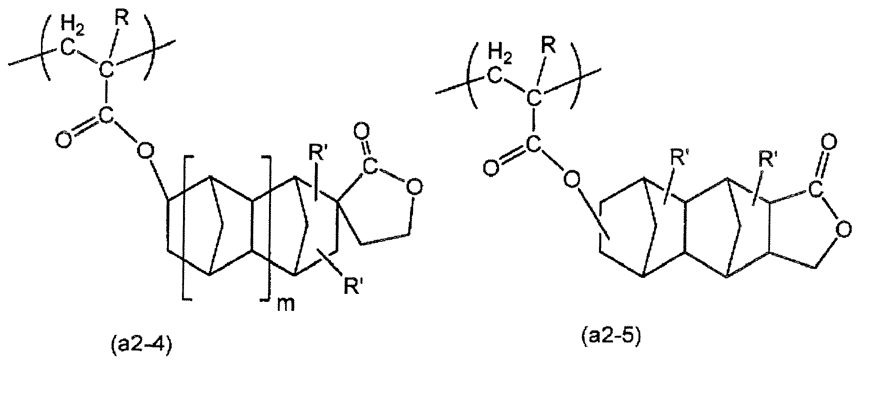

[wherein, R represents a hydrogen atom, halogen atom, lower alkyl group, or halogenated lower alkyl group, R' represents a hydrogen atom, a lower alkyl group, or an alkoxy group of 1 to 5 carbon atoms, and m represents an integer of 0 or 1]

The group R within the general formulas (a2-1) to (a2-5) is as defined above.
Examples of the lower alkyl group represented by R' within the general formulas (a2-1) to (a2-5) include the same lower alkyl groups as those described in relation to the group R. Considering factors such as industrial availability, R' is preferably a hydrogen atom.

Specific examples of structural units of the above general formulas (a2-1) to (a2-5) are shown below.

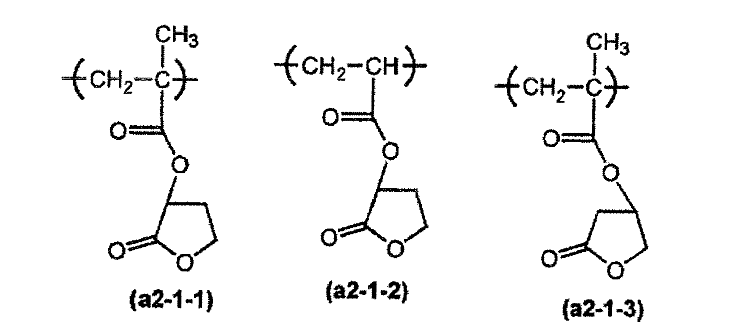

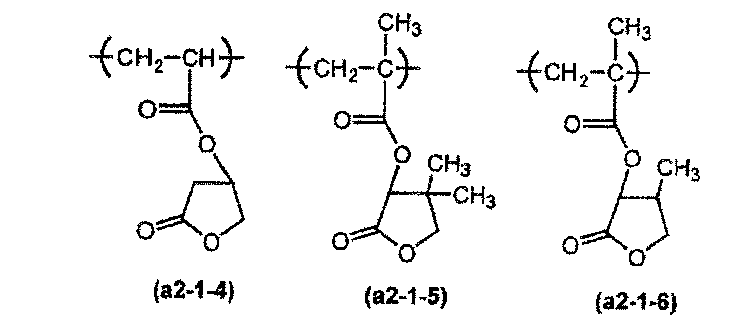

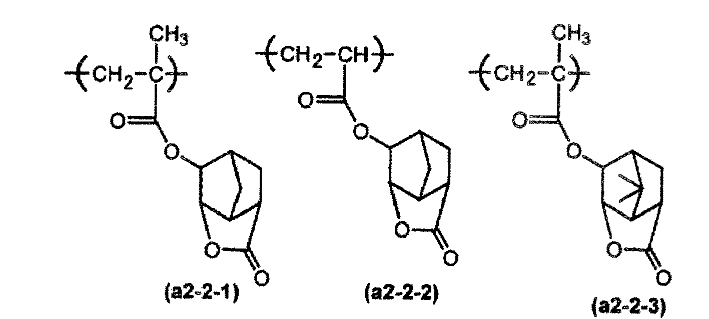

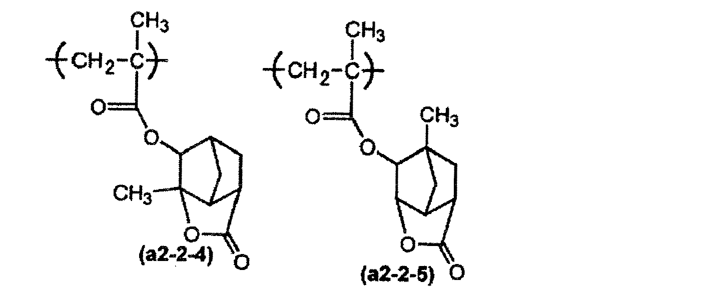

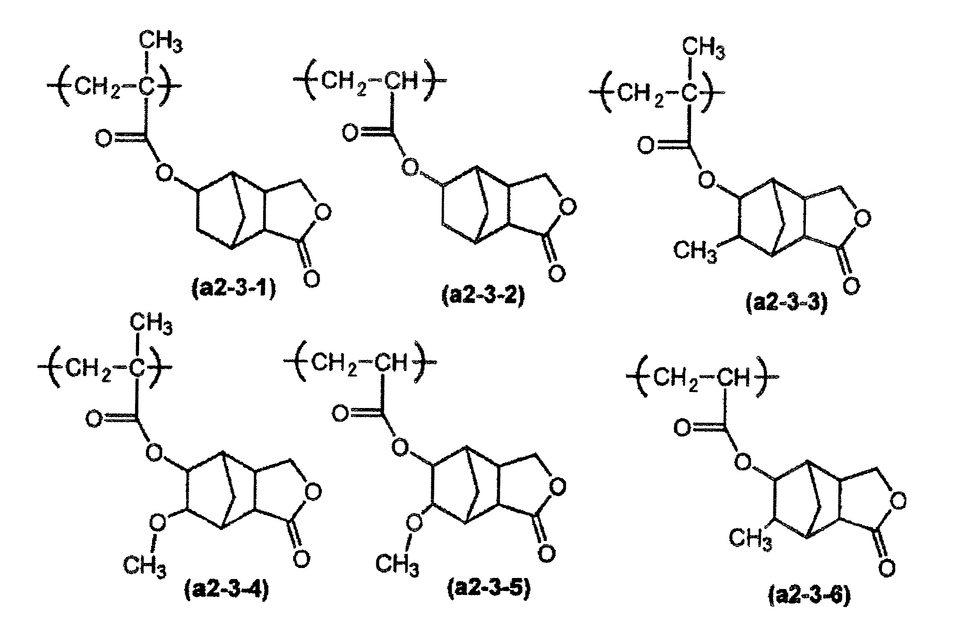

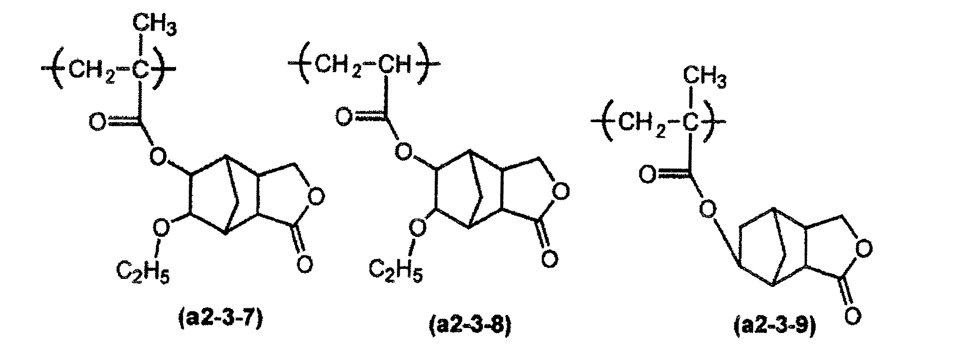

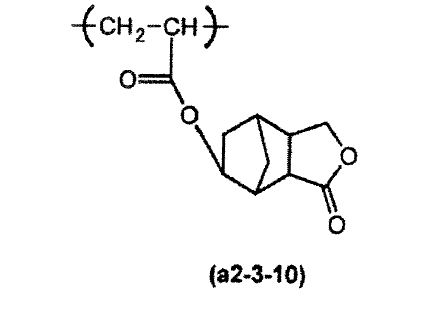

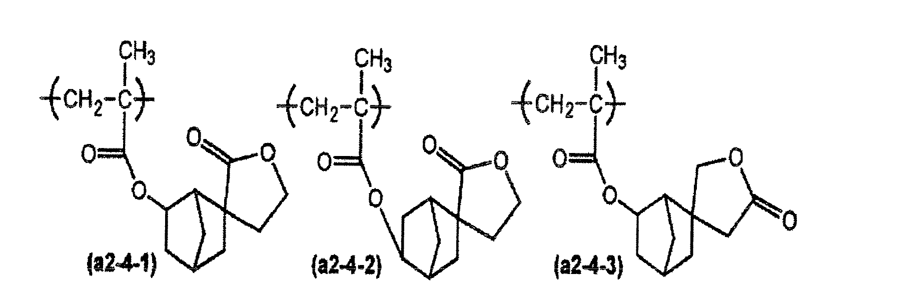

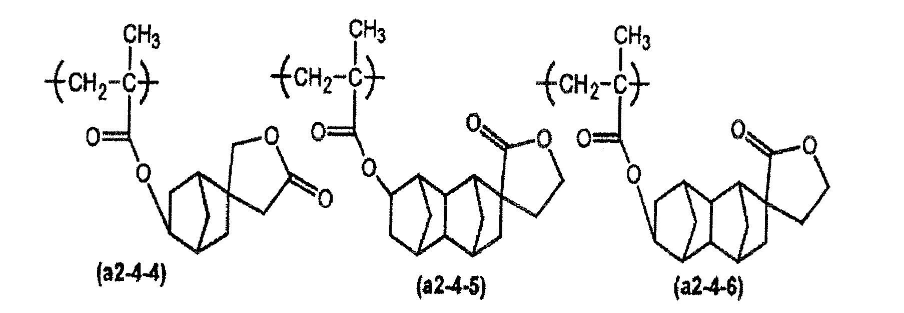

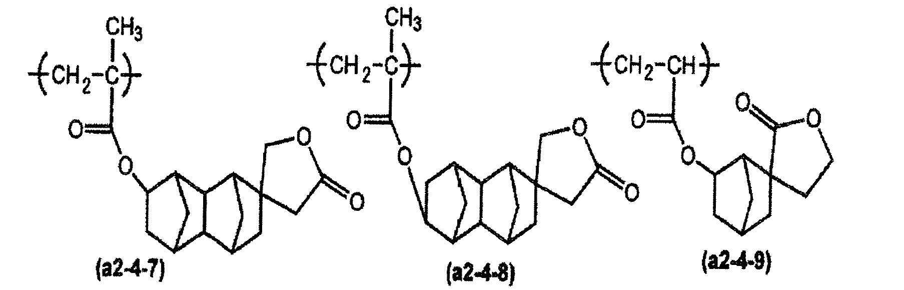

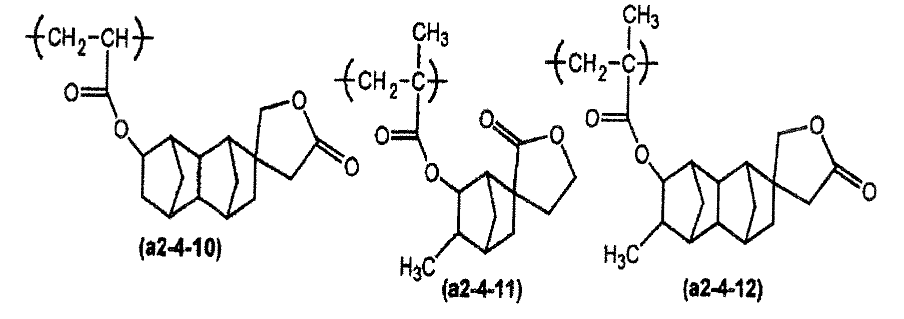

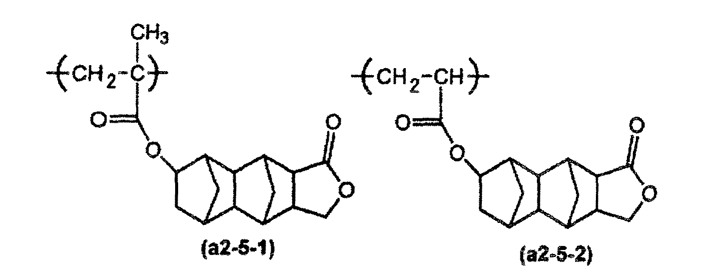

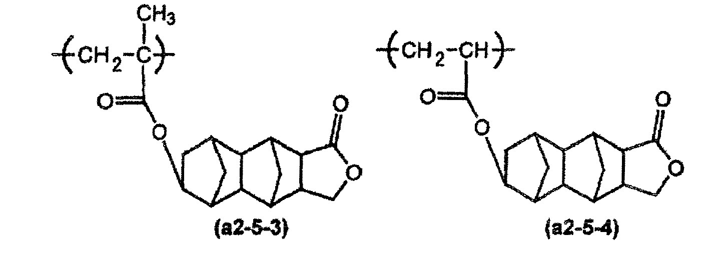

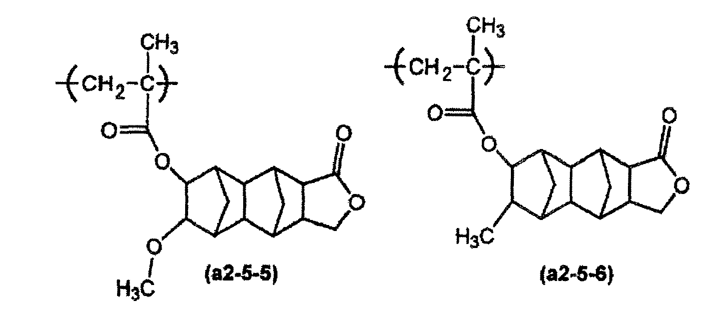

In the general formulas (a2-1) to (a2-5), considering factors such as industrial availability, R' is preferably a hydrogen atom.
Of the above structural units, the use of at least one structural unit selected from units of the general formulas (a2-1) to (a2-5) is preferred, and the use of at least one structural unit selected from units of the general formulas (a2-1) to (a2-3) is even more desirable. Specifically, the use of at least one structural unit selected from amongst the chemical formulas (a2-1-1), (a2-1-2), (a2-2-1), (a2-2-2), (a2-3-1), (a2-3-2), (a2-3-9), and (a2-3-10) is particularly preferred.

In the polymer compound (A1), as the structural unit (a2), either a single type of structural unit may be used alone, or a combination of two or more different structural units may be used.
The proportion of the structural unit (a2) within the polymer compound (A1), relative to the combined total of all the structural units that constitute the polymer compound (A1), is preferably within a range from 5 to 60 mol%, even more preferably from 10 to 50 mol%, and is most preferably from 20 to 50 mol%. Ensuring that this proportion is at least as large as the lower limit of this range enables the effects obtained by including the structural unit (a2) to be more readily realized, whereas ensuring that the proportion is no greater than the upper limit enables a more favorable balance to be achieved with the other structural units.

### - Structural Unit (a3)

In addition to the aforementioned structural unit (a0), or in addition to a combination of the structural units (a0) and (a1), or in addition to a combination of the structural units (a0) and (a2), or in addition to a combination of the structural units (a0), (a1) and (a2), the polymer compound (A1) may also include a structural unit (a3) derived from an acrylate ester that contains a polar group-containing aliphatic hydrocarbon group. Including the structural unit (a3) enhances the hydrophilicity of the component (A), thereby improving the affinity with the developing solution, improving the alkali solubility within the exposed portions of the resist, and contributing to an improvement in the resolution.

In the structural unit (a3), examples of the substituent group at the α-position of the acrylate ester include the same α-position substituent groups as those described above for the structural unit (a0).
Examples of the polar group include a hydroxyl group, cyano group, carboxyl group, or hydroxyalkyl group in which a portion of the hydrogen atoms of the alkyl group have been substituted with fluorine atoms or the like, although a hydroxyl group is particularly preferred.
Examples of the aliphatic hydrocarbon group include straight-chain or branched hydrocarbon groups (and preferably alkylene groups) of 1 to 10 carbon atoms, and polycyclic aliphatic hydrocarbon groups (polycyclic groups). These polycyclic groups can be selected appropriately from the multitude of groups that have been proposed for the resins of resist compositions designed for use with ArF excimer lasers.
Of the various possibilities, structural units that include an aliphatic polycyclic group that contains a hydroxyl group, cyano group, carboxyl group or a hydroxyalkyl group in which a portion of the hydrogen atoms of the alkyl group have been substituted with fluorine atoms, and are also derived from an acrylate ester are particularly preferred. Examples of suitable polycyclic groups include groups in which one or more hydrogen atoms have been removed from a bicycloalkane, tricycloalkane or tetracycloalkane or the like. Specific examples include groups in which one or more hydrogen atoms have been removed from a polycycloalkane such as adamantane, norbornane, isobornane, tricyclodecane or tetracyclododecane. These types of polycyclic groups can be selected appropriately from the multitude of groups proposed for the polymer (resin component) of resist compositions designed for use with ArF excimer lasers. Of these polycyclic groups, groups in which two or more hydrogen atoms have been removed from adamantane, groups in which two or more hydrogen atoms have been removed from norbornane, and groups in which two or more hydrogen atoms have been removed from tetracyclododecane are preferred industrially.

When the hydrocarbon group within the polar group-containing aliphatic hydrocarbon group is a straight-chain or branched hydrocarbon group of 1 to 10 carbon atoms, the structural unit (a3) is preferably a structural unit derived from the hydroxyethyl ester of the acrylic acid, whereas when the hydrocarbon group is a polycyclic group, examples of preferred structural units include the structural units represented by a formula (a3-1), the structural units represented by a formula (a3-2), and the structural units represented by a formula (a3-3), all of which are shown below.

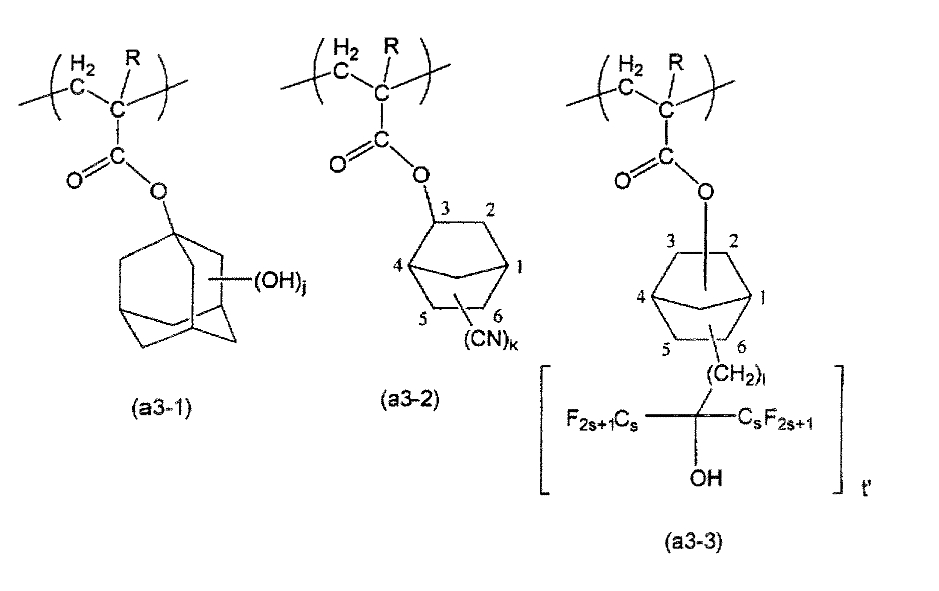

(wherein, R is as defined above, j represents an integer from 1 to 3, k represents an integer from 1 to 3, t' represents an integer from 1 to 3,1 represents an integer from I to 5, and s represents an integer from 1 to 3)

In the formula (a3-1), the value of j is preferably either 1 or 2, and is most preferably 1. In those cases where j is 2, the hydroxyl groups are preferably bonded to position 3 and position 5 of the adamantyl group. In those cases where j is 1, the hydroxyl group is preferably bonded to position 3 of the adamantyl group. The value of j is preferably 1, and units in which the hydroxyl group is bonded to position 3 of the adamantyl group are particularly desirable.

In the formula (a3-2), the value of k is preferably 1. The cyano group is preferably bonded to either position 5 or position 6 of the norbornyl group.

In the formula (a3-3), the value of t' is preferably 1. The value of 1 is also preferably 1. The value of s is also preferably 1. In these units, a 2-norbornyl group or 3-norbornyl group is preferably bonded to the carboxyl group terminal of the acrylic acid. A fluorinated alkyl alcohol is preferably bonded to either position 5 or 6 of the norbornyl group.

As the structural unit (a3), either a single type of structural unit may be used alone, or a combination of two or more different structural units may be used.
In those cases where the polymer compound (A1) includes a structural unit (a3), the proportion of the structural unit (a3) within the polymer compound (A1), relative to the combined total of all the structural units that constitute the polymer compound (A1), is preferably within a range from 5 to 50 mol%, even more preferably from 15 to 45 mol%, and is most preferably from 15 to 35 mol%.

In the present invention, in terms of maximizing the effects of the present invention, the polymer compound (A1) is preferably a copolymer that includes all of the structural units (a0) through (a3), and is most preferably a copolymer formed solely from the structural units (a0) through (a3).

### - Structural Unit (a4)

The polymer compound (A1) may also include other structural units (a4) besides the structural units (a0) to (a3) described above, provided the inclusion of these other units does not impair the effects of the present invention.
As the structural unit (a4), any other structural unit that cannot be classified as one of the above structural units (a0) through (a3) can be used without any particular restrictions, and any of the multitude of conventional structural units used within resist resins for ArF excimer lasers or KrF excimer lasers (and particularly for ArF excimer lasers) can be used.
As the structural unit (a4), a structural unit that contains a non-acid-dissociable aliphatic polycyclic group, and is also derived from an acrylate ester is preferred.
In the structural unit (a4), examples of the substituent group at the α-position of the acrylate ester include the same α-position substituent groups as those described above for the structural unit (a0).
Examples of the polycyclic group within the structural unit (a4) include the same groups as those described above in relation to the aforementioned structural unit (a1), and any of the multitude of conventional polycyclic groups used within the resin component of resist compositions for ArF excimer lasers or KrF excimer lasers (and particularly for ArF excimer lasers) can be used.
In particular, at least one group selected from amongst a tricyclodecanyl group, adamantyl group, tetracyclododecanyl group, isobornyl group, and norbornyl group is preferred in terms of factors such as industrial availability. These polycyclic groups may also be substituted with a straight-chain or branched alkyl group of 1 to 5 carbon atoms.
Specific examples of the structural unit (a4) include units with structures represented by general formulas (a4-1) to (a4-5) shown below.

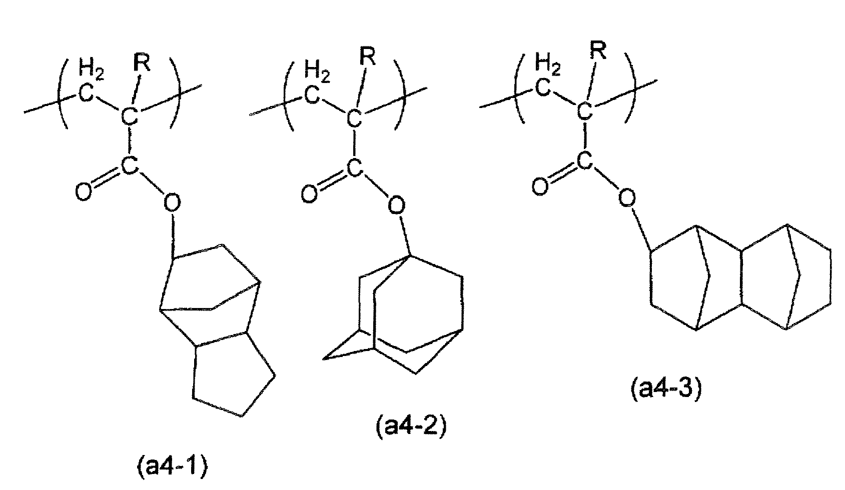

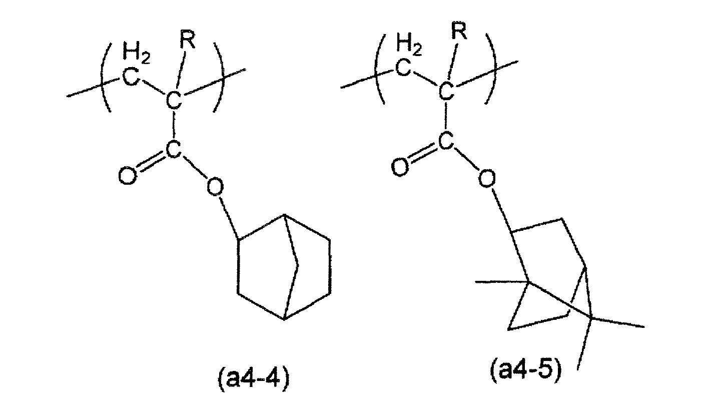

(wherein, R is as defined above)

Although the structural unit (a4) is not an essential component of the polymer compound (A1), if included within the polymer compound (A1), the proportion of the structural unit (a4), relative to the combined total of all the structural units that constitute the polymer compound (A1), is typically within a range from I to 30 mol%, and is preferably from 10 to 20 mol%.

The polymer compound (A1) can be obtained, for example, by a conventional radical polymerization or the like of the monomers that yield each of the structural units, using a radical polymerization initiator such as azobisisobutyronitrile (AIBN).
Furthermore, -C(CF₃)₂-OH groups may be introduced at the terminals of the polymer compound (A1) by also using a chain transfer agent such as HS-CH₂-CH₂-CH₂-C(CF₃)₂-OH during the above polymerization. A copolymer wherein hydroxyalkyl groups, in which a portion of the hydrogen atoms of the alkyl group have been substituted with fluorine atoms, have been introduced in this manner is effective in reducing the levels of developing defects and LER (line edge roughness: non-uniform irregularities within the line side walls).

Although there are no particular restrictions on the weight average molecular weight (Mw) (the polystyrene equivalent value determined by gel permeation chromatography) of the polymer compound (A1), the molecular weight value is preferably within a range from 2,000 to 30,000, even more preferably from 5,000 to 20,000, and is most preferably from 7,000 to 15,000.
Furthermore, the polydispersity (Mw/Mn) is preferably within a range from 1.0 to 5.0, even more preferably from 1.0 to 3.0, and is most preferably from 1.0 to 2.0.

In order to maximize the effects of the present invention, the proportion of the polymer compound (A1) within the component (A) is preferably at least 50% by weight, is even more preferably within a range from 80 to 100% by weight, and is most preferably 100% by weight.

In the polymer compound (A1), irradiation causes the generation of acid (such as sulfonate ions) from the structural unit (a0). As a result, the polymer compound (A1) combines the function of the base resin component within a conventional chemically amplified positive resist (namely, a resin component that exhibits changed alkali solubility upon exposure) and the function of an acid generator, meaning the polymer compound (A1) itself can be used for forming a resist composition.

In a resist composition for immersion exposure according to the present invention, in addition to the polymer compound (A1), the component (A) may also include a polymer compound (A2) that does not include the structural unit (a0).
There are no particular restrictions on the polymer compound (A2), provided it does not contain the structural unit (a0), although a resin that exhibits increased alkali solubility under the action of acid is preferred. As this resin that exhibits increased alkali solubility under the action of acid, one or more resins selected from those resins used as the resin component for conventional chemically amplified positive resists can be used.

More specific examples of the polymer compound (A2) include polymer compounds containing the aforementioned structural units (a1), (a2) and/or (a3) (hereafter referred to as the polymer compound (A2-1)).
Within the polymer compound (A2-1), the proportion of the structural unit (a1), relative to the combined total of all the structural units that constitute the polymer compound (A2-1), is preferably within a range from 5 to 80 mol%, and even more preferably from 10 to 70 mol%. Furthermore, the proportion of the structural unit (a3), relative to the combined total of all the structural units that constitute the polymer compound (A2-1), is preferably within a range from 5 to 50 mol%, and even more preferably from 10 to 40 mol%. Furthermore, the proportion of the structural unit (a2), relative to the combined total of all the structural units that constitute the polymer compound (A2-1), is preferably within a range from 5 to 80 mol%, and even more preferably from 10 to 60 mol%.
The polymer compound (A2-1) may also include an aforementioned structural unit (a4).
The weight average molecular weight of the polymer compound (A2-1) is preferably within a range from 5,000 to 30,000, and even more preferably from 6,000 to 20,000. Furthermore, the polydispersity (Mw/Mn) is preferably within a range from 1.0 to 5.0, and even more preferably from 1.0 to 3.0.
There are no particular restrictions on the proportion of the polymer compound (A2) within the component (A), although in order to ensure that the effects obtained by including the polymer compound (A2) manifest adequately, the polymer compounds are preferably mixed together in a ratio of polymer compound (A1) : polymer compound (A2) that falls within a range from 9:1 to 1:9 (weight ratio), and this ratio is even more preferably from 8:2 to 2:8, and is most preferably from 5:5 to 2:8.

The proportion of the component (A) within the resist composition for immersion exposure can be adjusted appropriately in accordance with the thickness of the target resist film.

A resist composition for immersion exposure according to the present invention can be produced by dissolving the aforementioned component (A), and any of the various optional materials described below, in an organic solvent.
The organic solvent may be any solvent capable of dissolving each of the components used to generate a uniform solution, and either one, or two or more solvents selected from known materials used as the solvents for conventional chemically amplified resists can be used.
Suitable examples include lactones such as γ-butyrolactone, ketones such as acetone, methyl ethyl ketone, cyclohexanone, methyl isoamyl ketone and 2-heptanone, polyhydric alcohols and derivatives thereof such as ethylene glycol, ethylene glycol monoacetate, diethylene glycol, diethylene glycol monoacetate, propylene glycol, propylene glycol monoacetate, dipropylene glycol, or the monomethyl ether, monoethyl ether, monopropyl ether, monobutyl ether or monophenyl ether of dipropylene glycol monoacetate, cyclic ethers such as dioxane, and esters such as methyl lactate, ethyl lactate (EL), methyl acetate, ethyl acetate, butyl acetate, methyl pyruvate, ethyl pyruvate, methyl methoxypropionate, and ethyl ethoxypropionate.
These organic solvents may be used either alone, or as a mixed solvent of two or more different solvents.
Furthermore, a mixed solvent of propylene glycol monomethyl ether acetate (PGMEA) and a polar solvent is preferred. In such cases, the mixing ratio (weight ratio) can be determined on the basis of the co-solubility of the PGMEA and the polar solvent, but is preferably within a range from 1:9 to 9:1, and even more preferably from 2:8 to 8:2.
More specifically, in those cases where EL is added as the polar solvent, the weight ratio of PGMEA:EL is preferably within a range from 1:9 to 9:1, and even more preferably from 2:8 to 8:2.
Furthermore, as the organic solvent, a mixed solvent of at least one of PGMEA and EL, together with γ-butyrolactone is also preferred. In such cases, the mixing ratio is set so that the weight ratio between the former and latter components is preferably within a range from 70:30 to 95:5.
There are no particular restrictions on the quantity used of the organic solvent, which is set in accordance with the desired film thickness so as to produce a concentration that enables favorable application to a substrate or the like, and is typically sufficient to produce a solid fraction concentration within the resist composition of 2 to 20% by weight, and preferably from 5 to 15% by weight.

Although not an essential component, the resist composition for immersion exposure according to the present invention may also include an acid generator component (B) that generates acid upon exposure (excluding the polymer compound (A1)), provided the inclusion of such an acid generator component does not impair the effects of the present invention.
As this acid generator component (B) (hereafter referred to as the component (B)), any of the acid generators proposed for use within conventional chemically amplified positive resist compositions can be used. Examples of these acid generators are numerous, and include onium salt-based acid generators such as iodonium salts and sulfonium salts, oxime sulfonate-based acid generators, diazomethane-based acid generators such as bisalkyl or bisaryl sulfonyl diazomethanes and poly(bis-sulfonyl)diazomethanes, nitrobenzyl sulfonate-based acid generators, iminosulfonate-based acid generators, and disulfone-based acid generators.

Examples of suitable onium salt-based acid generators include compounds represented by general formulas (b-1) and (b-2) shown below.

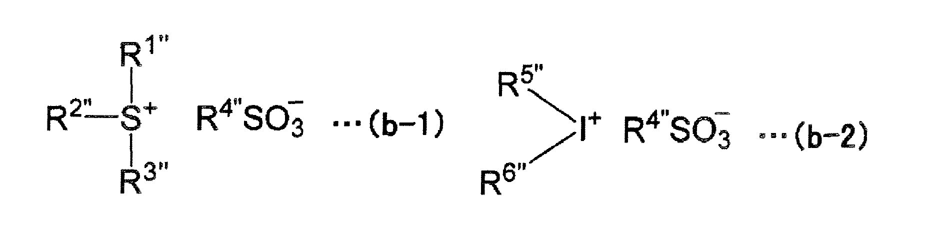

[wherein, R^{1"} to R^{3"}, and R^{5"} to R^{6"} each represent, independently, an aryl group or alkyl group; R^{4"} represents a straight-chain, branched or cyclic alkyl group or fluoroalkyl group; provided that at least one of R^{1"} to R^{3"} represents an aryl group, and at least one of R^{5"} to R^{6"} represents an aryl group]

In the formula (b-1), R¹" to R³" each represent, independently, an aryl group or alkyl group. Of the groups R¹" to R³", at least one group represents an aryl group. Compounds in which at least two of R¹" to R³" represent aryl groups are preferred, and compounds in which all of R^{1"} to R^{3"} are aryl groups are the most preferred.
There are no particular restrictions on the aryl groups of R¹" to R³", and suitable examples include aryl groups of 6 to 20 carbon atoms, in which either a portion of, or all of, the hydrogen atoms of these aryl groups may be either substituted, or not substituted, with alkyl groups, alkoxy groups, or halogen atoms and the like. In terms of enabling low-cost synthesis, aryl groups of 6 to 10 carbon atoms are preferred. Specific examples of suitable groups include a phenyl group and a naphthyl group.
Alkyl groups that may be used for substitution of the hydrogen atoms of the above aryl groups are preferably alkyl groups of 1 to 5 carbon atoms, and a methyl group, ethyl group, propyl group, n-butyl group or tert-butyl group are the most desirable.
Alkoxy groups that may be used for substitution of the hydrogen atoms of the above aryl groups are preferably alkoxy groups of 1 to 5 carbon atoms, and a methoxy group or ethoxy group are the most desirable. Halogen atoms that may be used for substitution of the hydrogen atoms of the above aryl groups are preferably fluorine atoms.
There are no particular restrictions on the alkyl groups of R^{1"} to R^{3"}, and suitable examples include straight-chain, branched, or cyclic alkyl groups of 1 to 10 carbon atoms. From the viewpoint of achieving excellent resolution, alkyl groups of 1 to 5 carbon atoms are preferred. Specific examples include a methyl group, ethyl group, n-propyl group, isopropyl group, n-butyl group, isobutyl group, n-pentyl group, cyclopentyl group, hexyl group, cyclohexyl group, nonyl group, and decanyl group, although in terms of achieving superior resolution and enabling low-cost synthesis, a methyl group is the most desirable.
Of the above possibilities, compounds in which R^{1"} to R^{3"} are all phenyl groups are the most preferred.

The group R^{4"} represents a straight-chain, branched or cyclic alkyl group or fluoroalkyl group. As the straight-chain alkyl group, groups of 1 to 10 carbon atoms are preferred, groups of 1 to 8 carbon atoms are even more preferred, and groups of 1 to 4 carbon atoms are the most desirable.
Suitable cyclic alkyl groups include the same groups as those listed above in relation to the group R^{1"}, and cyclic groups of 4 to 15 carbon atoms are preferred, groups of 4 to 10 carbon atoms are even more preferred, and groups of 6 to 10 carbon atoms are the most desirable.
As the above fluoroalkyl group, groups of 1 to 10 carbon atoms are preferred, groups of 1 to 8 carbon atoms are even more preferred, and groups of 1 to 4 carbon atoms are the most desirable. Furthermore, the fluorination ratio of the fluoroalkyl group (namely, the fluorine atom proportion within the alkyl group) is preferably within a range from 10 to 100%, and even more preferably from 50 to 100%, and groups in which all of the hydrogen atoms have been substituted with fluorine atoms yield the strongest acids, and are consequently the most desirable.
The group R^{4"} is most preferably a straight-chain or cyclic alkyl group, or a fluoroalkyl group.

In the formula (b-2), R^{5"} to R^{6"} each represent, independently, an aryl group or alkyl group. At least one of R^{5"} to R^{6"} represents an aryl group. Compounds in which at least two of R^{5"} to R^{6"} represent aryl groups are preferred, and compounds in which all of R^{5"} to R^{6"} are aryl groups are the most preferred.
Suitable examples of the aryl groups of the groups R^{5"} to R^{6"} include the same aryl groups as those described above for the groups R^{1"} to R^{3"}.
Suitable examples of the alkyl groups of the groups R^{5"} to R^{6"} include the same alkyl groups as those described above for the groups R^{1"} to R^{3"}.
Of the above possibilities, compounds in which R^{5"} to R^{6"} are all phenyl groups are the most preferred.
Suitable examples of the group R^{4"} in the formula (b-2) include the same groups as those described for the group R^{4"} in the aforementioned formula (b-1).

Specific examples of suitable onium salt-based acid generators include diphenyliodonium trifluoromethanesulfonate or nonafluorobutanesulfonate, bis(4-tert-butylphenyl)iodonium trifluoromethanesulfonate or nonafluorobutanesulfonate, triphenylsulfonium trifluoromethanesulfonate, heptafluoropropanesulfonate or nonafluorobutanesulfonate, tri(4-methylphenyl)sulfonium trifluoromethanesulfonate, heptafluoropropanesulfonate or nonafluorobutanesulfonate, dimethyl(4-hydroxynaphthyl)sulfonium trifluoromethanesulfonate, heptafluoropropanesulfonate or nonafluorobutanesulfonate, monophenyldimethylsulfonium trifluoromethanesulfonate, heptafluoropropanesulfonate or nonafluorobutanesulfonate, 38diphenylmonomethylsulfonium trifluoromethanesulfonate, heptafluoropropanesulfonate or nonafluorobutanesulfonate, (4-methylphenyl)diphenylsulfonium trifluoromethanesulfonate, heptafluoropropanesulfonate or nonafluorobutanesulfonate, (4-methoxyphenyl)diphenylsulfonium trifluoromethanesulfonate, heptafluoropropanesulfonate or nonafluorobutanesulfonate, tri(4-tert-butyl)phenylsulfonium trifluoromethanesulfonate, heptafluoropropanesulfonate or nonafluorobutanesulfonate, and diphenyl(1-(4-methoxy)naphthyl)sulfonium trifluoromethanesulfonate, heptafluoropropanesulfonate or nonafluorobutanesulfonate. Furthermore, onium salts in which the anion portion of the above onium salts have been substituted with methanesulfonate, n-propanesulfonate, n-butanesulfonate, or n-octanesulfonate can also be used.

Compounds in which the anion portion within the above general formulas (b-1) and (b-2) has been substituted with an anion portion represented by a general formula (b-3) or (b-4) shown below (and in which the cation portion is the same as that shown in (b-1) or (b-2)) can also be used.

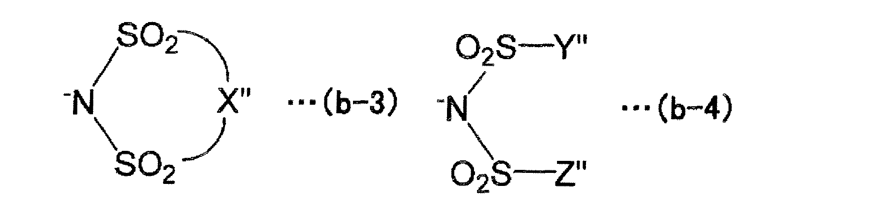

[wherein, X" represents an alkylene group of 2 to 6 carbon atoms in which at least one hydrogen atom has been substituted with a fluorine atom; Y" and Z" each represent, independently, an alkyl group of 1 to 10 carbon atoms in which at least one hydrogen atom has been substituted with a fluorine atom]

The group X" is a straight-chain or branched alkylene group in which at least one hydrogen atom has been substituted with a fluorine atom, and the number of carbon atoms within the alkylene group is typically within a range from 2 to 6, preferably from 3 to 5, and is most preferably 3.
Y" and Z" each represent, independently, a straight-chain or branched alkyl group in which at least one hydrogen atom has been substituted with a fluorine atom, and the number of carbon atoms within the alkyl group is typically within a range from 1 to 10, preferably from 1 to 7, and is most preferably from 1 to 3.
Within the above ranges for the numbers of carbon atoms, lower numbers of carbon atoms within the alkylene group X" or the alkyl groups Y" and Z" result in better solubility within the resist solvent, and are consequently preferred.
Furthermore, in the alkylene group X" or the alkyl groups Y" and Z", the larger the number of hydrogen atoms that have been substituted with fluorine atoms, the stronger the acid becomes, and the transparency relative to high energy light beams of 200 nm or less or electron beams also improves favorably. The fluorine atom proportion within the alkylene group or alkyl groups, namely the fluorination ratio, is preferably within a range from 70 to 100%, and even more preferably from 90 to 100%, and perfluoroalkylene or perfluoroalkyl groups in which all of the hydrogen atoms have been substituted with fluorine atoms are the most desirable.

In the present invention, the term "oxime sulfonate-based acid generator" describes a compound that contains at least one group represented by a general formula (B-1) shown below, and generates acid upon irradiation. These types of oxime sulfonate-based acid generators are widely used within chemically amplified resist compositions, and any of these conventional compounds can be used.

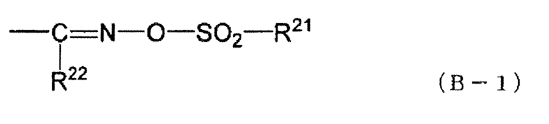

(In the formula (B-1), R²¹ and R²² each represent, independently, an organic group.)

In the present invention, the above organic groups preferably include carbon atoms, and may also include atoms other than carbon atoms (such as hydrogen atoms, oxygen atoms, nitrogen atoms, sulfur atoms, and halogen atoms (such as fluorine atoms or chlorine atoms)).
The organic group of R²¹ is preferably a straight-chain, branched or cyclic alkyl group or aryl group. These alkyl groups or aryl groups may also include a substituent group. There are no particular restrictions on such substituent groups, and suitable examples include a fluorine atom or a straight-chain, branched or cyclic alkyl group of 1 to 6 carbon atoms. Here, the expression "include a substituent group" means that either a portion of, or all of, the hydrogen atoms of the alkyl group or aryl group may be substituted with substituent groups.
The alkyl group preferably contains from 1 to 20 carbon atoms, even more preferably from I to 10 carbon atoms, even more preferably from 1 to 8 carbon atoms, even more preferably from 1 to 6 carbon atoms, and most preferably from 1 to 4 carbon atoms. Furthermore, alkyl groups that are partially or completely halogenated (hereafter also referred to as haloalkyl groups) are preferred. A partially halogenated alkyl group is an alkyl group in which a portion of the hydrogen atoms have been substituted with halogen atoms, whereas a completely halogenated alkyl group is an alkyl group in which all of the hydrogen atoms have been substituted with halogen atoms. Examples of the halogen atoms include fluorine atoms, chlorine atoms, bromine atoms or iodine atoms, although fluorine atoms are particularly desirable. In other words, the haloalkyl group is preferably a fluoroalkyl group.
The aryl group preferably contains from 4 to 20 carbon atoms, even more preferably from 4 to 10 carbon atoms, and most preferably from 6 to 10 carbon atoms. Aryl groups that are partially or completely halogenated are preferred. A partially halogenated aryl group is an aryl group in which a portion of the hydrogen atoms have been substituted with halogen atoms, whereas a completely halogenated aryl group is an aryl group in which all of the hydrogen atoms have been substituted with halogen atoms.
As the group R²¹, an alkyl group of 1 to 4 carbon atoms containing no substituent groups, or a fluoroalkyl group of 1 to 4 carbon atoms is the most desirable.

The organic group of R²² is preferably a straight-chain, branched or cyclic alkyl group or aryl group, or a cyano group. Examples of suitable alkyl groups and aryl groups for R²² include the same alkyl groups and aryl groups described above in relation to R²¹.
As the group R²², a cyano group, an alkyl group of 1 to 8 carbon atoms containing no substituent groups, or a fluoroalkyl group of 1 to 8 carbon atoms is the most desirable.

Particularly preferred oxime sulfonate-based acid generators include the compounds represented by the general formulas (B-2) and (B-3) shown below.

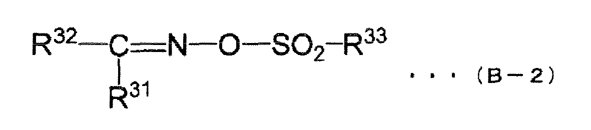

[In the formula (B-2), R³¹ represents a cyano group, an alkyl group containing no substituent groups, or a haloalkyl group. R³² represents an aryl group. R³³ represents an alkyl group containing no substituent groups, or a haloalkyl group.]

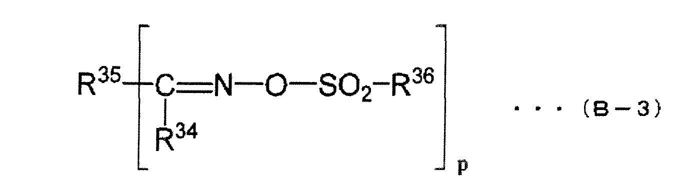

[In the formula (B-3), R³⁴ represents a cyano group, an alkyl group containing no substituent groups, or a haloalkyl group. R³⁵ represents a bivalent or trivalent aromatic hydrocarbon group. R³⁶ represents an alkyl group containing no substituent groups, or a haloalkyl group. p is either 2 or 3.]

In the above general formula (B-2), the alkyl group containing no substituent groups or haloalkyl group represented by R³¹ preferably contains from 1 to 10 carbon atoms, even more preferably from 1 to 8 carbon atoms, and most preferably from 1 to 6 carbon atoms.
The group R³¹ is preferably a haloalkyl group, and even more preferably a fluoroalkyl group.
In the fluoroalkyl group of R³¹, at least 50% of the hydrogen atoms of the alkyl group are preferably fluorinated, and this ratio is even more preferably 70% or higher, and is most preferably 90% or higher.

The aryl group represented by R³² is preferably a group in which one hydrogen atom has been removed from an aromatic hydrocarbon ring, such as a phenyl group, biphenylyl group, fluorenyl group, naphthyl group, anthracyl group or phenanthryl group, or a heteroaryl group in which a portion of the carbon atoms that constitute the ring structure within the above groups have been substituted with a hetero atom such as an oxygen atom, sulfur atom or nitrogen atom. Of these possibilities, a fluorenyl group is particularly preferred.
The aryl group of R³² may include a substituent group such as an alkyl group, haloalkyl group or alkoxy group of 1 to 10 carbon atoms. The alkyl group or haloalkyl group substituent groups preferably contain from 1 to 8 carbon atoms, and even more preferably I to 4 carbon atoms. Furthermore, the haloalkyl group is preferably a fluoroalkyl group.

The alkyl group containing no substituent groups or haloalkyl group represented by R³³ preferably contains from 1 to 10 carbon atoms, even more preferably from 1 to 8 carbon atoms, and most preferably from 1 to 6 carbon atoms.
The group R³³ is preferably a haloalkyl group, even more preferably a fluoroalkyl group, and is most preferably a partially fluorinated alkyl group.
In the fluoroalkyl group of R³³, at least 50% of the hydrogen atoms of the alkyl group are preferably fluorinated, and groups in which 70% or more, and even more preferably 90% or more, of the hydrogen atoms are fluorinated are particularly desirable as they increase the strength of the acid that is generated. Completely fluorinated alkyl groups in which 100% of the hydrogen atom have been substituted with fluorine atoms are the most desirable.

In the above general formula (B-3), examples of the alkyl group containing no substituent groups or haloalkyl group represented by R³⁴ include the same alkyl groups containing no substituent groups and haloalkyl groups described above for the group R³¹.
Examples of the bivalent or trivalent aromatic hydrocarbon group represented by R³⁵ include groups in which a further one or two hydrogen atoms respectively are removed from an aryl group of the aforementioned group R³².
Examples of the alkyl group containing no substituent groups or haloalkyl group represented by R³⁶ include the same alkyl groups containing no substituent groups and haloalkyl groups described above for the group R³³.
p is preferably 2.

Specific examples of suitable oxime sulfonate-based acid generators include α-(p-toluenesulfonyloxyimino)-benzyl cyanide, α-(p-chlorobenzenesulfonyloxyimino)-benzyl cyanide, α-(4-nitrobenzenesulfonyloxyimino)-benzyl cyanide, α-(4-nitro-2-trifluoromethylbenzenesulfonyloxyimino)-benzyl cyanide, α-(benzenesulfonyloxyimino)-4-chlorobenzyl cyanide, α-(benzenesulfonyloxyimino)-2,4-dichlorobenzyl cyanide, α-(benzenesulfonyloxyimino)-2,6-dichlorobenzyl cyanide, α-(benzenesulfonyloxyimino)-4-methoxybenzyl cyanide, α-(2-chlorobenzenesulfonyloxyimino)-4-methoxybenzyl cyanide, α-(benzenesulfonyloxyimino)-thien-2-yl acetonitrile, α-(4-dodecylbenzenesulfonyloxyimino)-benzyl cyanide, α-[(p-toluenesulfonyloxyimino)-4-methoxyphenyl] acetonitrile, α-[(dodecylbenzenesulfonyloxyimino)-4-methoxyphenyl] acetonitrile, α-(tosyloxyimino)-4-thienyl cyanide, α-(methylsulfonyloxyimino)-1-cyclopentenyl acetonitrile, α-(methylsulfonyloxyimino)-1-cyclohexenyl acetonitrile, α-(methylsulfonyloxyimino)-1-cycloheptenyl acetonitrile, α-(methylsulfonyloxyimino)-1-cyclooctenyl acetonitrile, α-(trifluoromethylsulfonyloxyimino)-1-cyclopentenyl acetonitrile, α-(trifluoromethylsulfonyloxyimino)-cyclohexyl acetonitrile, α-(ethylsulfonyloxyimino)-ethyl acetonitrile, α-(propylsulfonyloxyimino)-propyl acetonitrile, α-(cyclohexylsulfonyloxyimino)-cyclopentyl acetonitrile, α-(cyclohexylsulfonyloxyimino)-cyclohexyl acetonitrile, α-(cyclohexylsulfonyloxyimino)-1-cyclopentenyl acetonitrile, α-(ethylsulfonyloxyimino)-1-cyclopentenyl acetonitrile, α-(isopropylsulfonyloxvimino)-1-cyclopentenyl acetonitrile, α-(n-butylsulfonyloxyimino)-1-cyclopentenyl acetonitrile, α-(ethylsulfonyloxyimino)-1-cyclohexenyl acetonitrile, α-(isopropylsulfonyloxyimino)-1-cyclohexenyl acetonitrile, α-(n-butylsulfonyloxyimino)-1-cyclohexenyl acetonitrile, α-(methylsulfonyloxyimino)-phenyl acetonitrile, α-(methylsulfonyloxyimino)-p-methoxyphenyl acetonitrile, α-(trifluoromethylsulfonyloxyimino)-phenyl acetonitrile, α-(trifluoromethylsulfonyloxyimino)-p-methoxyphenyl acetonitrile, α-(ethylsulfonyloxyimino)-p-methoxyphenyl acetonitrile, α-(propylsulfonyloxyimino)-p-methylphenyl acetonitrile, and α-(methylsulfonyloxyimino)-p-bromophenyl acetonitrile.
Furthermore, further examples include the compounds represented by the chemical formulas shown below.

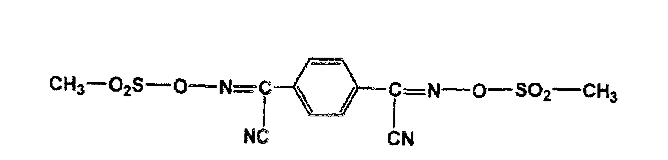

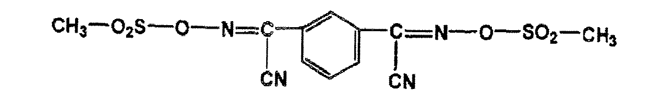

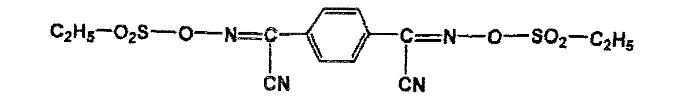

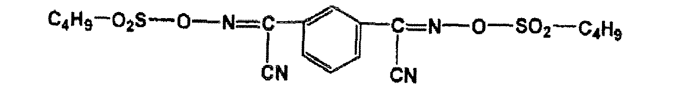

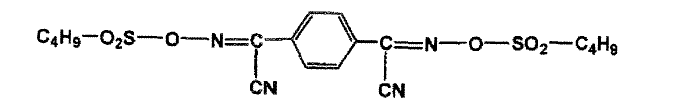

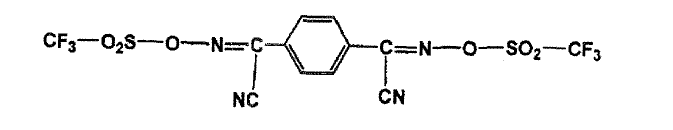

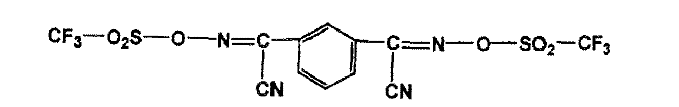

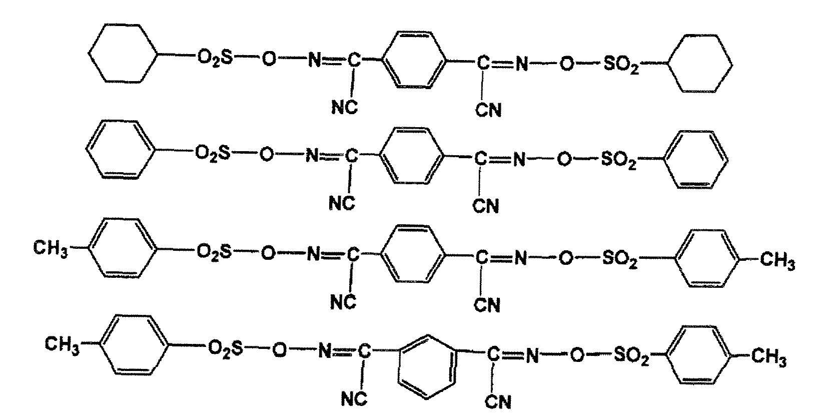

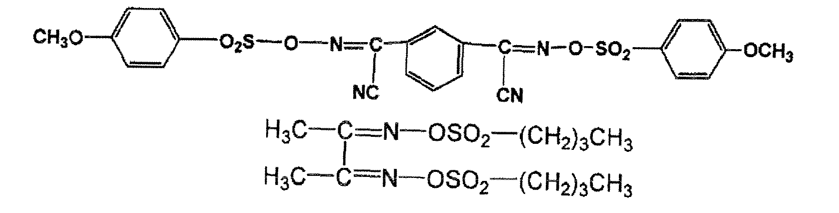

Furthermore, of the compounds represented by the aforementioned general formulas (B-2) and (B-3), examples of particularly preferred compounds include those shown below.

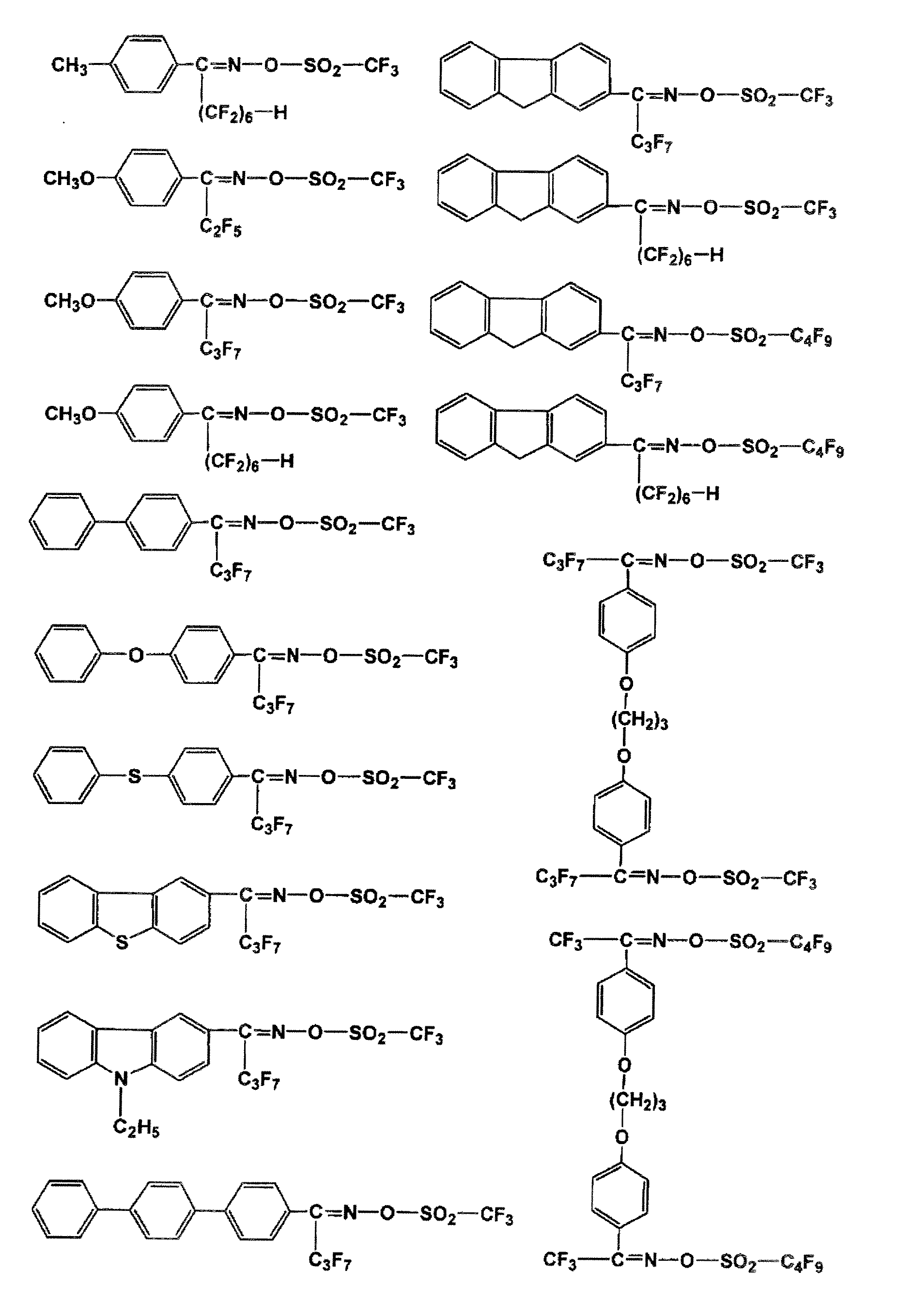

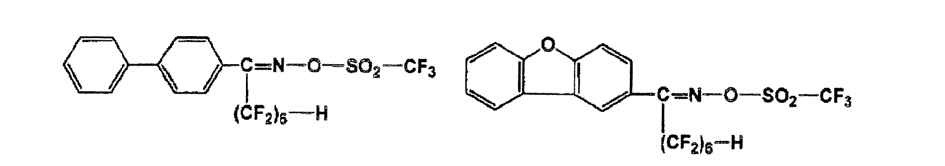

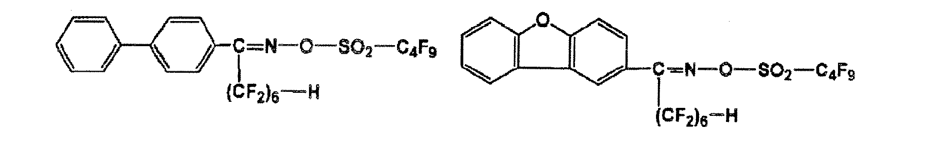

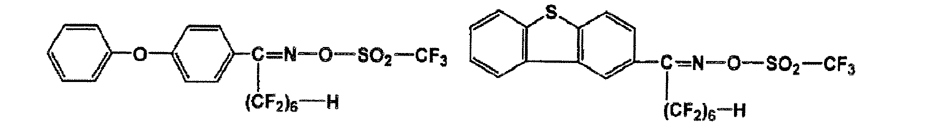

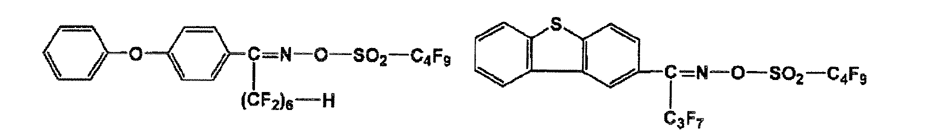

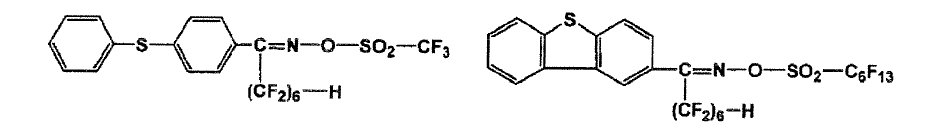

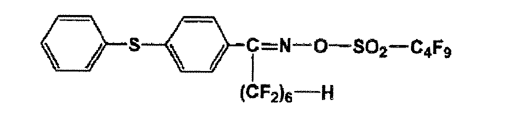

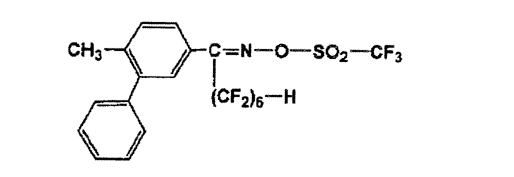

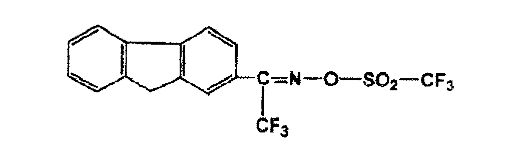

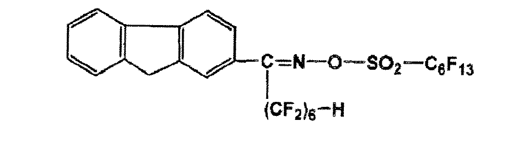

Of the above compounds, the three compounds shown below are particularly desirable.

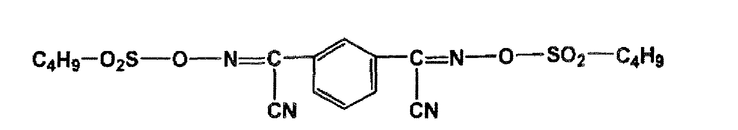

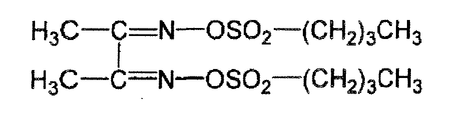

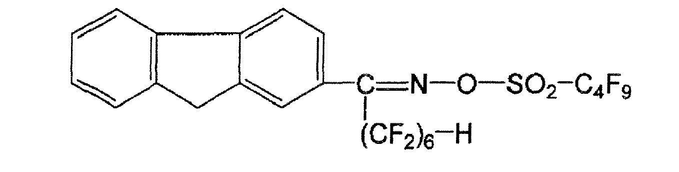

Of the various diazomethane-based acid generators, specific examples of suitable bisalkyl or bisaryl sulfonyl diazomethanes include bis(isopropylsulfonyl)diazomethane, bis(p-toluenesulfonyl)diazomethane, bis(1,1-dimethylethylsulfonyl)diazomethane, bis(cyclohexylsulfonyl)diazomethane, and bis(2,4-dimethylphenylsulfonyl)diazomethane.
Furthermore, specific examples of poly(bis-sulfonyl)diazomethanes include the structures shown below, such as 1,3-bis(phenylsulfonyldiazomethylsulfonyl)propane (wherein A=3), 1,4-bis(phenylsulfonyldiazomethylsulfonyl)butane (wherein A=4), 1,6-bis(phenylsulfonyldiazomethylsulfonyl)hexane (wherein A=6), 1,10-bis(phenylsulfonyldiazomethylsulfonyl)decane (wherein A = 10), 1,2-bis(cyclohexylsulfonyldiazomethylsulfonyl)ethane (wherein B=2), 1,3-bis(cyclohexylsulfonyldiazomethylsulfonyl)propane (wherein B=3), 1,6-bis(cyclohexylsulfonyldiazomethylsulfonyl)hexane (wherein B=6), and 1,10-bis(cyclohexylsulfonyldiazomethylsulfonyl)decane (wherein B= 10).

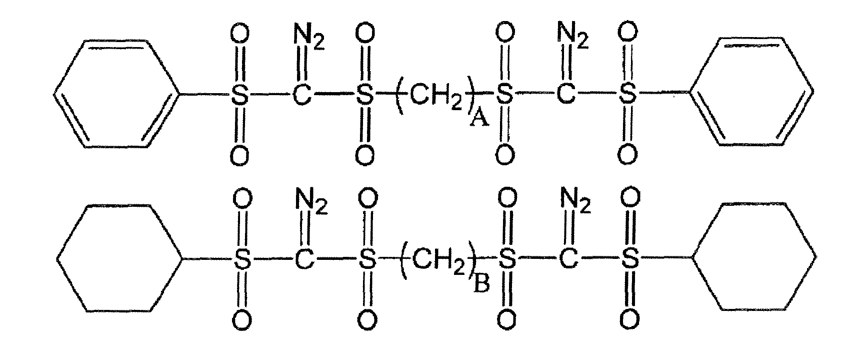

As the component (B), either a single acid generator may be used alone, or a combination of two or more of these acid generators may be used.
In the resist composition for immersion exposure, the blend quantity of the component (B) is typically no more than 10 parts by weight, and preferably within a range from 0.1 to 5 parts by weight, per 200 parts by weight of the component (A). If this quantity exceeds 10 parts by weight, then the effects of the present invention may be lost.

In the resist composition for immersion exposure according to the present invention, in order to improve the resist pattern shape and the post exposure stability of the latent image formed by the pattern-wise exposure of the resist layer, a nitrogen-containing organic compound (D) (hereafter referred to as the component (D)) may be added as an optional component.
A multitude of these nitrogen-containing organic compounds have already been proposed, and any of these known compounds can be used, and suitable examples include monoalkylamines such as n-hexylamine, n-heptylamine, n-octylamine, n-nonylamine, and n-decylamine; dialkylamines such as diethylamine, di-n-propylamine, di-n-heptylamine, di-n-octylamine, and dicyclohexylamine; trialkylamines such as trimethylamine, triethylamine, tri-n-propylamine, tri-n-butylamine, tri-n-hexylamine, tri-n-pentylamine, tri-n-heptylamine, tri-n-octylamine, tri-n-nonylamine, tri-n-decanylamine, and tri-n-dodecylamine; and alkyl alcohol amines such as diethanolamine, triethanolamine, diisopropanolamine, triisopropanolamine, di-n-octanolamine, and tri-n-octanolamine. Of these compounds, secondary aliphatic amines and tertiary aliphatic amines are preferred, trialkylamines of 5 to 10 carbon atoms are even more preferred, and tri-n-octylamine is the most desirable.
Furthermore, nitrogen-containing organic compounds represented by a general formula (VI) shown below can also be favorably employed.

N(R^{11'}-O-R^{12'}-O-R^{13'})₃ (VI)

(wherein, R^{11'} and R^{12'} each represent, independently, a lower alkylene group, and R^{13'} represents a lower alkyl group)

R^{11'}, R^{12'} and R^{13'} may be straight chains, branched chains, or cyclic structures, although straight chains and branched chains are preferred.
From the viewpoint of regulating the molecular weight, the number of carbon atoms within each of R^{11'}, R^{12'} and R^{13'} is typically within a range from 1 to 5, and is preferably from 1 to 3. The number of carbon atoms in R^{11'}, R^{12'} and R^{13'} may be either the same or different. Moreover, the structures of R^{11'} and R^{12'} may be either the same or different.
Examples of compounds represented by the general formula (VI) include tris-(2-methoxymethoxyethyl)amine, tris-2-(2-methoxy(ethoxy))ethylamine, and tris-(2-(2-methoxyethoxy)methoxyethyl)amine. Of these, tris-2-(2-methoxy(ethoxy))ethylamine is preferred.
Of the above components (D), compounds represented by the above general formula (VI) are preferred, and tris-2-(2-methoxy(ethoxy))ethylamine in particular exhibits minimal solubility in the solvents used in immersion exposure or immersion lithography processes, and is consequently preferred.

These compounds may be used either alone, or in combinations of two or more different compounds.
The component (D) is typically added in a quantity within a range from 0.01 to 5.0 parts by weight per 100 parts by weight of the component (A).

Furthermore, in order to prevent any deterioration in sensitivity caused by the addition of the aforementioned component (D), and improve the resist pattern shape and the post exposure stability of the latent image formed by the pattern-wise exposure of the resist layer, an organic carboxylic acid, or a phosphorus oxo acid or derivative thereof (E) (hereafter referred to as the component (E)) may also be added as an optional component to the resist composition for immersion exposure according to the present invention. The component (D) and the component (E) can be used in combination, or either one can also be used alone.
Examples of suitable organic carboxylic acids include malonic acid, citric acid, malic acid, succinic acid, benzoic acid, and salicylic acid.
Examples of suitable phosphorus oxo acids or derivatives thereof include phosphoric acid or derivatives thereof such as esters, including phosphoric acid, di-n-butyl phosphate and diphenyl phosphate; phosphonic acid or derivatives thereof such as esters, including phosphonic acid, dimethyl phosphonate, di-n-butyl phosphonate, phenylphosphonic acid, diphenyl phosphonate and dibenzyl phosphonate; and phosphinic acid or derivatives thereof such as esters, including phosphinic acid and phenylphosphinic acid, and of these, phosphonic acid is particularly preferred.
The component (E) is typically used in a quantity within a range from 0.01 to 5.0 parts by weight per 100 parts by weight of the component (A).

Other miscible additives can also be added to a resist composition for immersion exposure according to the present invention according to need, and examples include additive resins for improving the performance of the resist film, surfactants for improving the coating properties, dissolution inhibitors, plasticizers, stabilizers, colorants, halation prevention agents, and dyes and the like.

Production of a resist composition for immersion exposure according to the present invention can be conducted by simply mixing and stirring each of the above components together using conventional methods, and where required, the composition may also be mixed and dispersed using a dispersion device such as a dissolver, a homogenizer, or a triple roll mill. Furthermore, following mixing, the composition may also be filtered using a mesh or a membrane filter or the like.

### «Method for Resist Pattern Formation»

Next is a description of a method for resist pattern formation according to the present invention.
First, a resist composition for immersion exposure according to the present invention is applied to the surface of a substrate such as a silicon wafer using a spinner or the like, and a prebake (PAB treatment) is then performed.
An organic or inorganic anti-reflective film may also be provided between the substrate and the applied layer of the resist composition, creating a 2-layer laminate.
Furthermore, a 2-layer laminate in which an organic anti-reflective film is provided on top of the applied layer of the resist composition for immersion exposure can also be formed, and a 3-layer laminate comprising an additional bottom layer anti-reflective film can also be formed. The anti-reflective film provided on top of the resist layer is preferably soluble in alkali developing solutions.
The steps up until this point can be conducted using conventional techniques. The operating conditions and the like are preferably set in accordance with the makeup and the characteristics of the resist composition being used.

Subsequently, the above resist layer formed from the applied film of the resist composition for immersion exposure is subjected to selective immersion exposure (liquid immersion lithography) through a desired mask pattern. At this time, the region between the resist layer and the lens at the lowermost point of the exposure apparatus is pre-filled with a solvent that has a larger refractive index than the refractive index of air, and the exposure is preferably conducted with this region filled with a solvent which exhibits a refractive index that is larger than the refractive index of air but smaller than the refractive index of the resist layer.
There are no particular restrictions on the wavelength used for the exposure, and an ArF excimer laser, KrF excimer laser or F₂ laser or the like can be used. A resist composition according to the present invention is particularly useful for KrF or ArF excimer lasers, and is particularly effective for ArF excimer lasers.

As described above, in a formation method of the present invention, during exposure, the region between the resist layer and the lens at the lowermost point of the exposure apparatus is preferably filled with a solvent which exhibits a refractive index that is larger than the refractive index of air but smaller than the refractive index of the resist composition being used.
Examples of this solvent which exhibits a refractive index that is larger than the refractive index of air but smaller than the refractive index of the resist composition being used include water, fluorine-based inert liquids, and silicon-based solvents.
Specific examples of the fluorine-based inert liquids include liquids containing a fluorine-based compound such as C₃HCl₂F₅, C₄F₉OCH₃, C₄F₉OC₂H₅ or C₅H₃F₇ as the primary component, or perfluoroalkyl compounds with a boiling point within a range from 70 to 180°C and preferably from 80 to 160°C. Examples of these perfluoroalkyl compounds include perfluoroalkylether compounds and perfluoroalkylamine compounds.
Specifically, one example of a suitable perfluoroalkylether compound is perfluoro(2-butyl-tetrahydrofuran) (boiling point 102°C), and an example of a suitable perfluoroalkylamine compound is perfluorotributylamine (boiling point 174°C).
Amongst these fluorine-based inert liquids, liquids with a boiling point that falls within the above range enable the removal of the medium used as the immersion liquid following completion of the exposure to be performed using a simple method, and are consequently preferred.

A resist composition for immersion exposure according to the present invention is particularly resistant to any adverse effects caused by water, and because the resulting sensitivity and shape of the resist pattern profile are excellent, water is preferably used as the solvent which exhibits a refractive index that is larger than the refractive index of air. Furthermore, water is also preferred in terms of cost, safety, environmental friendliness, and general flexibility.
Furthermore, there are no particular restrictions on the refractive index of the solvent, provided it is larger than the refractive index of air but smaller than the refractive index of the resist composition being used.

Subsequently, following completion of the exposure step, PEB (post exposure baking) is conducted, and then a developing treatment is performed using an alkali developing liquid formed from an aqueous alkali solution. The substrate is then preferably rinsed with pure water. This water rinse is conducted by dripping or spraying water onto the surface of the substrate while it is rotated, and washes away the developing solution and those portions of the resist composition that have been dissolved by the developing solution. By conducting a subsequent drying treatment, a resist pattern is obtained in which the film of the resist composition has been patterned into a shape corresponding with the mask pattern.

In this manner, by using a positive resist composition for immersion exposure and a method for resist pattern formation according to the present invention, a resist pattern such as a fine line and space (L&S) pattern with a line width of 90 nm or less can be formed with a favorable pattern shape.
The reasons that the present invention enables the formation of a resist pattern of superior shape are not entirely clear, although the following reasons are thought likely. Namely, in immersion exposure, the resist layer is in contact with the immersion solvent medium during immersion exposure, as described above. In those cases where a conventional low molecular weight acid generator is used, it is thought that contact with the immersion solvent causes elution of the acid generator into the immersion solvent, which causes phenomena such as degeneration of the resist layer and fluctuations in the refractive index of the immersion solvent, resulting in a deterioration in the resist pattern shape. In contrast, with a resist composition for immersion exposure according to the present invention, it is thought that because the acid-generating groups are supported within the polymer compound, elution into the immersion solvent is inhibited and any fluctuations in the refractive index of the immersion solvent are also suppressed, which results in significant improvements in the swelling of the pattern and the level of LER, thereby yielding an improved resist pattern shape. In addition, because the acid-generating groups exist within the polymer compound itself, the acid-generating groups are distributed uniformly throughout the resist film with no localization, and it is surmised that as a result, the levels of surface roughness and LER can be improved, enabling an improvement in the resist pattern shape.
Moreover, it is surmised that because elution of the acid generator into the immersion solvent is inhibited, suppression of resist film degeneration and fluctuations in the refractive index of the immersion solvent can be expected.

### EXAMPLES

As follows is a description of examples of the present invention, although the scope of the present invention is in no way limited by these examples.
The monomer components (1) through (4) used in the synthesis examples described below have the structures shown below.

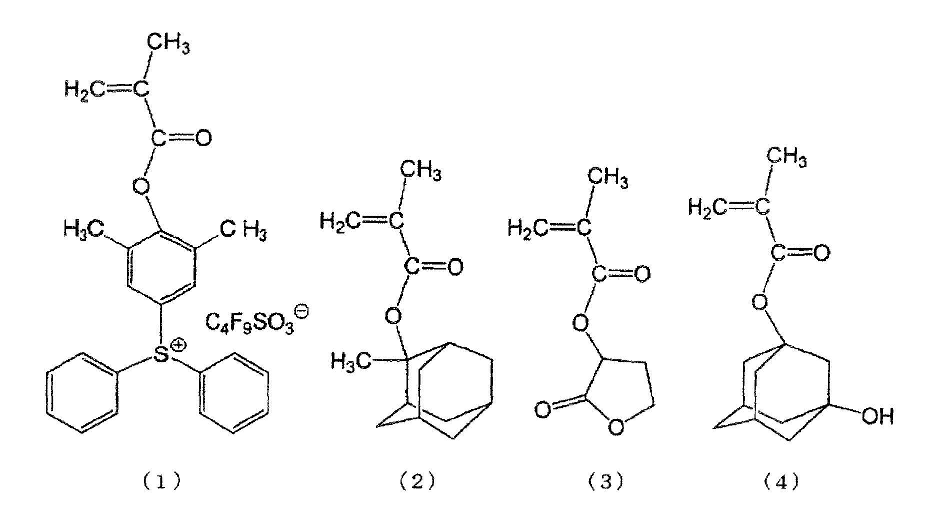

### [Synthesis Example 1]

0.7 g of the monomer component (1), 10.0 g of the monomer component (2), 7.2 g of the monomer component (3), and 5.0 g of the monomer component (4) were dissolved in 100 ml of tetrahydrofuran, and 0.35 g of azobisisobutyronitrile was added. Following refluxing for 6 hours, the reaction solution was added dropwise to 1 L of n-heptane. The precipitated resin was collected by filtration and dried under reduced pressure, yielding a white resin powder. This resin was termed resin 1, and the structural formula for the resin is shown below. The weight average molecular weight (Mw) of the resin I was 10,600, and the polydispersity (Mw/Mn) was 1.8. Furthermore, analysis by carbon-13 nuclear magnetic resonance spectroscopy (¹³C-NMR) revealed a compositional ratio (molar ratio) between each of the structural units shown in the structural formula below of a:b:c:d = 36.4 : 38.6 : 23.9 : 1.1.

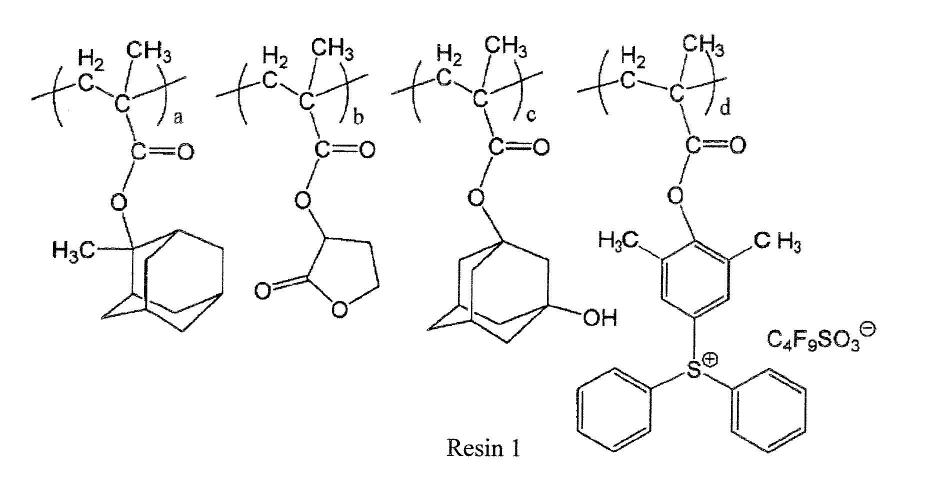

### [Comparative Synthesis Example 1]

18.7 g of the monomer component (2), 13.6 g of the monomer component (3), and 9.5 g of the monomer component (4) were dissolved in 200 ml of tetrahydrofuran, and 1.64 g of azobisisobutyronitrile was added. Following refluxing for 6 hours, the reaction solution was added dropwise to I L of n-heptane. The precipitated resin was collected by filtration and dried under reduced pressure, yielding a white resin powder. This resin was termed resin 2, and the structural formula for the resin is shown below. The weight average molecular weight (Mw) of the resin 2 was 13,300, and the polydispersity (Mw/Mn) was 2.5. Furthermore, analysis by carbon-13 nuclear magnetic resonance spectroscopy (¹³C-NMR) revealed a compositional ratio (molar ratio) between each of the structural units shown in the structural formula below of a:b:c = 33.6 : 43.8 : 22.6.

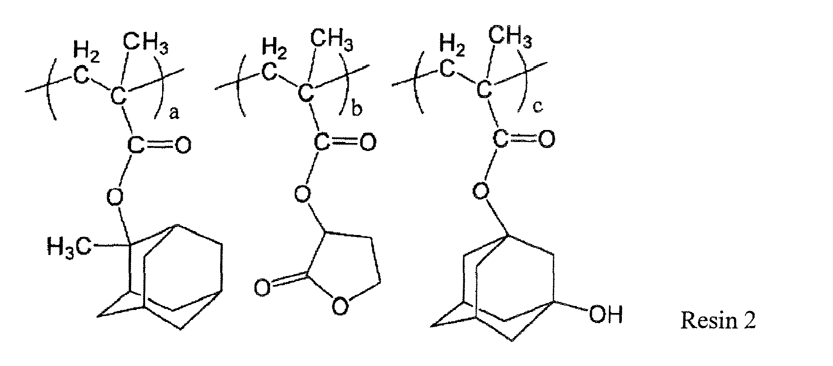

### Example 1

100 parts by weight of the resin 1 and 0.3 parts by weight of tri-n-octylamine were dissolved in a mixed solvent of propylene glycol monomethyl ether acetate (PGMEA) and ethyl lactate (EL) (PGMEA:EL = 6:4 (weight ratio)), thus yielding a positive resist composition solution with a solid fraction concentration of 5% by weight.

Subsequently, the thus obtained positive resist composition solution was evaluated in the manner described below.

### [Immersion Exposure Evaluation]

An organic anti-reflective film material (product name: ARC-29, manufactured by Brewer Science Ltd.) was applied to the surface of an 8-inch silicon wafer, and the composition was then baked at 225°C for 60 seconds, thereby forming an organic anti-reflective film with a thickness of 77 nm and completing preparation of the substrate. The positive resist composition solution obtained above was applied uniformly across the surface of this substrate using a spinner, and was then prebaked and dried on a hotplate at 130°C for 90 seconds, thereby forming a resist layer with a film thickness of 130 nm.
Subsequently, immersion exposure was conducted using a double beam interference lithography apparatus LEIES 193-1 (manufactured by Nikon Corporation), by performing immersion double beam interference exposure using a prism, water and the interference of two light beams of 193 nm. The same method is disclosed in the aforementioned non-patent reference 2 (Journal of Vacuum Science & Technology B (U.S.), 2001, vol. 19, issue 6, pp. 2353 to 2356), and this method is widely known as a simple method of obtaining a line and space (L&S) pattern at the laboratory level.
Next, a PEB treatment was conducted at 120°C for 90 seconds, puddle development was conducted for 30 seconds at 23°C in a 2.38% by weight aqueous solution of tetramethylammonium hydroxide, the resist was subsequently washed for 30 seconds using pure water, and the resist was then shaken dry, thereby forming a line and space (1:1) resist pattern (hereafter referred to as a L/S pattern).

Inspection of the thus obtained L/S pattern using a SEM revealed a resist pattern in which 65 nm lines and spaces had been formed at a ratio of 1:1. Furthermore, the resist pattern shape showed no swelling of the lines, and roughness within the pattern side walls and the like was also minimal.

### [Comparative Example 1]

With the exceptions of using the resin 2 instead of the resin 1, and adding 3.5 parts by weight of triphenylsulfonium nonafluorobutanesulfonate as an acid generator, a positive resist composition solution was prepared in the same manner as the example 1, and this resist composition was then evaluated in the same manner as that described above.

Inspection of the thus obtained L/S pattern using a SEM revealed a resist pattern in which 65 nm lines and spaces had been formed at a ratio of 1:1. However, the resist pattern shape exhibited marked swelling of the lines, and roughness within the pattern side walls was also considerable.

As is evident from the above results, according to the positive resist composition of the example I, which uses the resin 1 that corresponds with the polymer compound (A1), a resist pattern of favorable shape was able to be formed with a high level of resolution by using an immersion exposure process.
On the other hand, according to the positive resist composition of the comparative example I, which uses the resin 2 that contains no acid-generating groups and includes a separate low molecular weight acid generator, the shape of the resist pattern formed using immersion exposure was poor.

### INDUSTRIAL APPLICABILITY

A resist composition for immersion exposure and a method for resist pattern formation that enable the formation of a resist pattern of favorable shape are provided.

## Claims

1. A resist composition for immersion exposure comprising:
a resin component (A) that exhibits changed alkali solubility under action of acid, wherein
said resin component (A) includes a polymer compound (A1) containing a structural unit (a0) having an acid-generating group that generates acid upon irradiation.

2. A resist composition for immersion exposure according to claim 1, wherein said acid-generating group is a group containing a sulfonate ion.

3. A resist composition for immersion exposure according to claim 1, wherein said structural unit (a0) is a structural unit derived from an acrylate ester.

4. A resist composition for immersion exposure according to claim 3, wherein said structural unit (a0) is a structural unit represented by a general formula (a0-1) shown below: 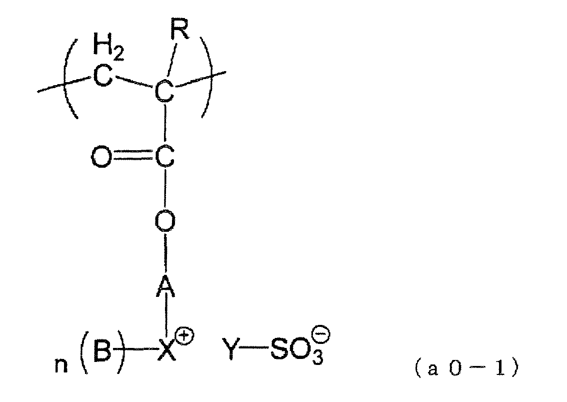 [wherein, R represents a hydrogen atom, halogen atom, lower alkyl group, or halogenated lower alkyl group; A represents a bivalent organic group; B represents a monovalent organic group; X represents a sulfur atom or iodine atom; n represents either 1 or 2; and Y represents a straight-chain, branched or cyclic alkyl group in which at least one hydrogen atom may be substituted with a fluorine atom].

5. A resist composition for immersion exposure according to claim 4, wherein said structural unit (a0) is a structural unit represented by a general formula (a0-2) shown below: 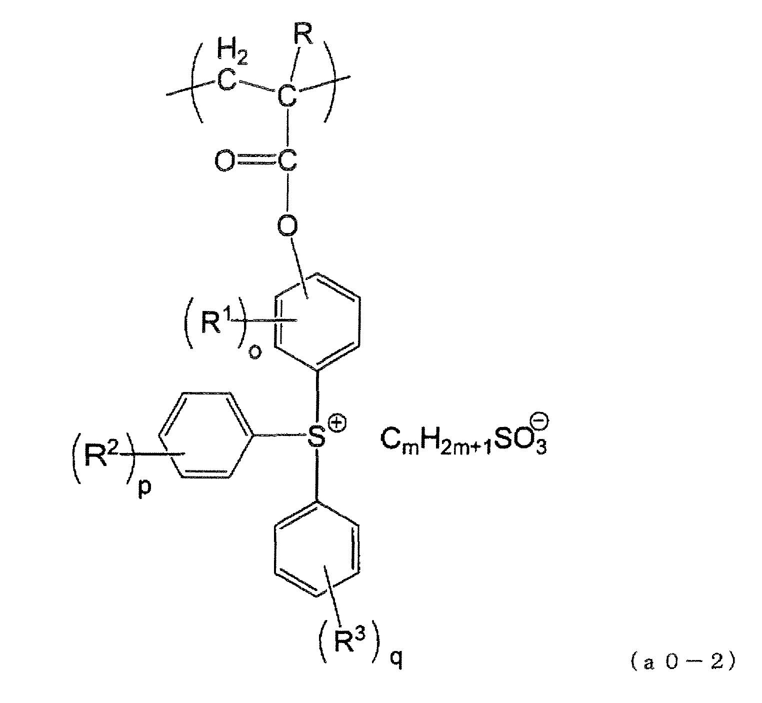 [wherein, R represents a hydrogen atom, halogen atom, lower alkyl group, or halogenated lower alkyl group; R¹ to R³ each represent, independently, a straight-chain, branched, or cyclic alkyl group of 1 to 20 carbon atoms, or a hydroxyl group; o, p, and q each represent, independently, either 0 or an integer from 1 to 3; m represents an integer from 1 to 10; and a hydrogen atom within an anion portion may be substituted with a fluorine atom].

6. A resist composition for immersion exposure according to claim 5, wherein said structural unit (a0) is a structural unit represented by a general formula (a0-3) shown below: 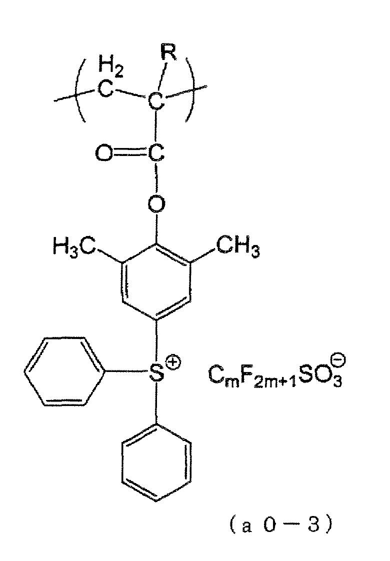 [wherein, R represents a hydrogen atom, halogen atom, lower alkyl group, or halogenated lower alkyl group; and m represents an integer from 1 to 10].

7. A resist composition for immersion exposure according to claim 1, wherein a proportion of said structural unit (a0), relative to a combined total of all structural units that constitute said polymer compound (A1), is at least 0.01 mol%.

8. A resist composition for immersion exposure according to claim 1, wherein said polymer compound (A1) also includes a structural unit (a1) derived from an acrylate ester containing an acid-dissociable, dissolution-inhibiting group.

9. A resist composition for immersion exposure according to claim 8, wherein a proportion of said structural unit (a1), relative to a combined total of all structural units that constitute said polymer compound (A1), is within a range from 10 to 80 mol%.

10. A resist composition for immersion exposure according to claim 1, wherein said polymer compound (A1) also includes a structural unit (a2) derived from an acrylate ester that contains a lactone-containing monocyclic or polycyclic group.

11. A resist composition for immersion exposure according to claim 8, wherein said polymer compound (A1) also includes a structural unit (a2) derived from an acrylate ester that contains a lactone-containing monocyclic or polycyclic group.

12. A resist composition for immersion exposure according to claim 10, wherein a proportion of said structural unit (a2), relative to a combined total of all structural units that constitute said polymer compound (A1), is within a range from 5 to 60 mol%.

13. A resist composition for immersion exposure according to claim 1, wherein said polymer compound (A1) alsoincludes a structural unit (a3) derived from an acrylate ester that contains a polar group-containing aliphatic polycyclic group.

14. A resist composition for immersion exposure according to claim 8, wherein said polymer compound (A1) also includes a structural unit (a3) derived from an acrylate ester that contains a polar group-containing aliphatic polycyclic group.

15. A resist composition for immersion exposure according to claim 10, wherein said polymer compound (A1) also includes a structural unit (a3) derived from an acrylate ester that contains a polar group-containing aliphatic polycyclic group.

16. A resist composition for immersion exposure according to claim 11, wherein said polymer compound (A1) also includes a structural unit (a3) derived from an acrylate ester that contains a polar group-containing aliphatic polycyclic group.

17. A resist composition for immersion exposure according to claim 13, wherein a proportion of said structural unit (a3), relative to a combined total of all structural units that constitute said polymer compound (A1), is within a range from 5 to 50 mol%.

18. A resist composition for immersion exposure according to claim 1, further comprising a nitrogen-containing organic compound (D).

19. A method for resist pattern formation, comprising the steps of: forming a resist film on a substrate using said resist composition for immersion exposure according to any one of claim 1 through claim 18, conducting immersion exposure of said resist film, and developing said resist film to form a resist pattern.
